# EUROPEAN PATENT APPLICATION

(11) **EP 1 528 601 A2**
(43) Date of publication of application: **04.05.2005**
(21) Application number: 04292520.6
(22) Date of filing: 25.10.2004
(51) Int. Cl.: H01L 31/075, H01L 31/18

(54) **Solar cell and process for producing solar cell**

(30) Priority: 27.10.2003 JP 2003366602
(71) Applicant: Mitsubishi Heavy Industries, Ltd., Tokyo 108-8215 (JP)
(72) Inventor: Goya, Saneyuki c/o Adv Tech Research Cntr, Kanazawa-ku Yokohama Kanagawa 236-8515 (JP); Nakano, Youji c/o Adv Tech Research Cntr, Kanazawa-ku Yokohama Kanagawa 236-8515 (JP); Miyamoto, Yoshiki c/o Daiya Staff Ltd, Yokohama Kanagawa-ken 231-0812 (JP)
(74) Representative: Joly, Jean-Jacques

(57) **Abstract**

A process for producing a solar cell is provided which can enhance the photovoltaic conversion efficiency by enlarging the grain sizes in the direction of the thickness of an i-layer to reduce grain boundaries, thereby avoiding recombination of carriers and activating the dopant at the same time. A process for producing a solar cell includes depositing at least a first transparent electrode (12), polycrystalline silicon layers in a PIN structure (13, 14, 15), and a second electrode (16) in sequence on an electrically insulating substrate (11), the polycrystalline silicon layers in a PIN structure including a p-type silicon layer (13), an i-type silicon layer (14), and an n-type silicon layer (15), wherein the polycrystalline silicon layers in a PIN structure are formed by : forming a p-type silicon layer (13), which is then subjected to thermal annealing; depositing an i-type silicon layer (14) on the p-type silicon layer; and depositing an n-type silicon layer (15) on the i-type silicon layer.

## Description

### BACKGROUND OF THE INVENTION

### 1. FIELD OF THE INVENTION

The present invention relates to solar cells and to processes for producing solar cells. In particular, the present invention relates to thin film silicon-type solar cells and to processes for producing crystalline silicon-type solar cells.

Priority is claimed on Japanese Patent Application No. 2003-366602, filed October 27, 2003, the content of which is incorporated herein by reference.

### 2. DESCRIPTION OF RELATED ART

Use of solar cells which use amorphous silicon has begun in small scale electricity generation such as in watches, small calculators, and streetlights, followed by uses for electric power for industries and houses. However, there still remain obstacles to be overcome such as low conversion efficiency, in comparison with solar cells of bulk silicon types such as a single crystal or a polycrystal, and degradation. Such obstacles are considered as disadvantages of amorphous silicon solar cells. Means for overcoming these disadvantages as disclosed in Japanese Unexamined Patent Application, First Publication (Kokai), No. Hei 6-5896, for example, are known.

On the other hand, in a solar cell having thin-film crystalline silicon layers (which may include polycrystalline Si or microcrystalline Si) in a PIN structure, it is known that improvement in quality of an i-type polycrystalline Si layer, which is an electricity generation layer, is effective in enhancement of the photovoltaic conversion efficiency.

A thin-film crystalline silicon formed by a low-temperature process around 200°C is comprised of a crystalline phase of small grains and an amorphous phase. In many cases where a film of microcrystalline silicon is formed, a mixed gas obtained by highly diluting silane, which is a raw material, with hydrogen is normally used. By raising the dilution ratio, the volume fraction of the crystalline portion is increased.

However, if a mixed gas which is rich in hydrogen is used in deposition of an i-layer, which is an electricity generation layer, a large number of crystal nucleation are occurred, and crystals grow from these crystal nuclei to form microcrystalline grains having small grain sizes. There has been a problem in that such increase in the number of microcrystalline grains results in increase in the number of grain boundaries which extend in the direction intersecting the direction of the thickness of the Si layers, and thus results in increase in the number of defects, which promote recombination of carriers, shortening the lifetime of the carriers, thereby making it difficult to improve cell performance.

On the other hand, a small number of crystal nucleation at the beginning of crystal growth and amorphous-rich condition at the beginning of formation of the i-layer also adversely affect cell performance.

As a means for growing crystal grains in the Si layers, a two-stage film deposition method is known in which conditions for forming the film of the i-layer are switched during the deposition of the film so as to control nucleation and growth of crystals separately. However, even this two-stage film deposition method is not sufficient to reduce grain boundaries.

In addition, it is also known that photovoltaic conversion efficiency can be enhanced by increasing the electric conductivity of either of n-layer and p-layer, between which the i-layer is interposed. Thermal annealing is an effective method for this purpose. However, if thermal annealing for increasing the electric conductivity is carried out after forming PIN layers, a problem arises in some cases in that dopants in the n- and p-layers diffuse into the i-layer, resulting in reduction in photovoltaic conversion efficiency.

### BRIEF SUMMARY OF THE INVENTION

The present invention was made in view of the above circumstances, and an object of the present invention is to provide a process for producing a solar cell which can enhance the photovoltaic conversion efficiency by enlarging the grain sizes in the direction of the thickness of an i-layer to reduce grain boundaries in the direction of the growth of grains, thereby avoiding recombination of carriers.

Another object of the present invention is to provide a process for producing a solar cell which can enhance the photovoltaic conversion efficiency by increasing the electric conductivities of an n-layer and a p-layer without changing the quality of an i-layer.

Yet another object of the present invention is to provide a solar cell in which electric conductivities of an n-layer and a p-layer are high and the sizes of grains in an i-layer are large in the direction the thickness of the i-layer, thereby possessing high photovoltaic conversion efficiency.

In order to achieve the above objects, the present invention employs the following arrangements.

A process for producing a solar cell according to the present invention includes depositing at least a first electrode, polycrystalline silicon layers in a PIN or NIP structure, and a second electrode in sequence on an electrically insulating substrate, the polycrystalline silicon layers in a PIN or NIP structure including a p-type silicon layer, an i-type silicon layer, and an n-type silicon layer, wherein the polycrystalline silicon layers in a PIN or NIP structure are formed by: forming a p-type or n-type silicon layer, which is then subjected to thermal annealing; depositing an i-type silicon layer on the p-type or n-type silicon layer; and depositing an n-type or p-type silicon layer on the i-type silicon layer.

Here, "polycrystalline silicon" is a layer formed, for example, by plasma enhanced CVD at a temperature as low as around 200°C, and includes microcrystalline silicon.

According to this arrangement, the dopant in the p-type or n-type silicon layer is activated so that the electric conductivity of the p-type or n-type silicon layer can be enhanced, and the built-in potential is increased by shifting the respective Fermi level within the band gap toward the valence band (p-type) or the conduction band (n-type) so that a solar cell which provides excellent photovoltaic conversion efficiency can be produced.

Furthermore, since thermal annealing is carried out before the i-type silicon layer is deposited, the dopant in the p-type or n-type silicon layer on the first electrode does not diffuse into the i-type silicon layer, and the performance of the solar cell is not degraded.

Here, it is preferable that the first electrode be composed of a transparent electrode. It is also preferable that the second electrode be composed of a transparent electrode and a back electrode.

Alternatively, a process for producing a solar cell according to the present invention includes depositing at least a first electrode, polycrystalline silicon layers in a PIN or NIP structure, and a second electrode in sequence on an electrically insulating substrate, the polycrystalline silicon layers in a PIN or NIP structure including a p-type silicon layer, an i-type silicon layer, and an n-type silicon layer, wherein the polycrystalline silicon layers in a PIN or NIP structure are formed by: forming a p-type or n-type silicon layer, which is then subjected to thermal annealing in a low-pressure oxygen atmosphere; depositing an i-type silicon layer on the p-type or n-type silicon layer; and depositing an n-type or p-type silicon layer on the i-type silicon layer.

In the present invention, low-pressure oxygen atmospheres include the gas at an atmospheric pressure or lower in which the entire gas is oxygen and the mixture gas at an atmospheric pressure or lower containing oxygen and an inert gas.

It is preferable that the pressure of the oxygen atmosphere be in the range of 0.1 to 760 Torr (13 Pa to 0.1 MPa).

According to this arrangement, the dopant in the p-type silicon layer or n-type silicon layer is activated so that the electric conductivity of the p-type silicon layer or the n-type silicon layer can be enhanced, and a solar cell which provides excellent photovoltaic conversion efficiency can be produced.

Furthermore, since thermal annealing is carried out before the i-type silicon layer is deposited, the dopant in the p-type silicon layer or n-type silicon layer on the first electrode does not diffuse into the i-type silicon layer, and the performance of the solar cell is not degraded.

Moreover, the thermal annealing in the low-pressure oxygen atmosphere forms a silicon oxide film on the p-type or n-type silicon layer which is formed on the first electrode. When the i-type silicon layer is formed on this silicon oxide film, initial crystal nucleation in the i-type silicon layer is suitably inhibited. As a result, growth of crystal grains in the direction of the thickness of the polycrystalline silicon layers is promoted. Accordingly, performance of a solar cell, in which recombination of carriers in the i-type silicon layer is suppressed, can be improved.

In a process for producing a solar cell according to the present invention, it is preferable that the thermal annealing be carried out at a temperature not lower than 80°C and not higher than 200°C. It is more preferable that the thermal annealing be carried out at a temperature not lower than 100°C and not higher than 150°C.

According to this arrangement, a solar cell which provides excellent photovoltaic conversion performance can be produced.

In the process for producing a solar cell according to the present invention, amorphous silicon layers in a PIN or NIP structure may be formed between the first or second electrode and the polycrystalline silicon layers in a PIN or NIP structure.

In the process for producing a solar cell according to the present invention, the polycrystalline silicon layers in a PIN or NIP structure may be further deposited with other polycrystalline silicon layers in a PIN or NIP structure.

In the process for producing a solar cell according to the present invention, the aforesaid other polycrystalline silicon layers in a PIN or NIP structure may be formed by: forming a p-type or n-type silicon layer, which is then subjected to thermal annealing; depositing an i-type silicon layer on the p-type or n-type silicon layer; and further depositing an n-type or p-type silicon layer on the i-type silicon layer.

In the process for producing a solar cell according to the present invention, the aforesaid other polycrystalline silicon layers in a PIN or NIP structure may be formed by: forming a p-type or n-type silicon layer, which is then subjected to thermal annealing in a low-pressure oxygen atmosphere; depositing an i-type silicon layer on the p-type or n-type silicon layer; and depositing an n-type or p-type silicon layer on the i-type silicon layer.

In a solar cell according to the present invention having at least a first electrode, polycrystalline silicon layers in a PIN or NIP structure, and a second electrode, which are deposited in sequence on an electrically insulating substrate, the polycrystalline silicon layers comprise a p-type silicon layer, an i-type silicon layer, and an n-type silicon layer, which are deposited in sequence or in reverse, and the p-type silicon layer or the n-type silicon layer, whichever is on the side closer to the electrically insulating substrate with respect to the i-type silicon layer, has been subjected to thermal annealing.

The thermal annealing of the p-type or n-type silicon layer activates the dopant in the p-type or n-type silicon layer on the first electrode so that the electric conductivity of the p-type or n-type silicon layer can be enhanced, and the built-in potential is increased by shifting the respective Fermi level within the band gap toward the valence band (p-type) or the conduction band (n-type) so that the photovoltaic conversion efficiency of a solar cell can be improved.

In another solar cell according to the present invention, having at least a first electrode, polycrystalline silicon layers in a PIN or NIP structure, and a second electrode, which are deposited in sequence on an electrically insulating substrate, the polycrystalline silicon layers comprise a p-type silicon layer, an i-type silicon layer, and an n-type silicon layer, which are deposited in sequence or in reverse, and have an oxide film formed between the i-type silicon layer and the p-type silicon layer or the n-type silicon layer, whichever is on the side closer to the electrically insulating substrate with respect to the i-type silicon layer.

Since an oxide film is formed on the p-type or n-type silicon layer which is formed on the first electrode, crystal nucleation in the i-type silicon layer is reduced, and formation of small size grains in the i-type silicon layer can be inhibited. As a result, growth of crystal grains in the direction of the thickness of the polycrystalline silicon layers can be promoted. Accordingly, performance of a solar cell, in which recombination of carriers in the i-type silicon layer is suppressed, can be improved.

Another solar cell according to the present invention is an above-described solar cell wherein the oxide film is formed by carrying out thermal annealing in a low-pressure oxygen atmosphere after the p-type silicon layer or the n-type silicon layer is deposited on the first electrode.

The thermal annealing in the low-pressure oxygen atmosphere forms an oxide film on the p-type or n-type silicon layer which is formed on the first electrode. When the i-type silicon layer is formed on this silicon oxide film, crystal nucleation in the i-type silicon layer is reduced. As a result, growth of crystal grains in the direction of the thickness of the polycrystalline silicon layers can be promoted. Accordingly, performance of a solar cell, in which recombination of carriers in the i-type silicon layer is inhibited, can be improved.

As described above, by a process for producing a solar cell according to the present invention, thermal annealing of the n-type silicon layer or the p-type silicon layer on the first electrode before the i-type silicon layer is deposited enhances the electric conductivity of the n-type silicon layer or the p-type silicon layer without changing quality of the i-type silicon layer, and allows production of a solar cell which provides excellent photovoltaic conversion efficiency.

In addition, by a process for producing a solar cell according to the present invention, formation of the oxide film as an underlying film for the i-type silicon layer enlarges the grain sizes in the direction of the thickness of the i-type silicon layer so as to suppress recombination of carriers, and allows production of a solar cell which provides excellent photovoltaic conversion efficiency.

Moreover, with a solar cell according to the present invention, the electric conductivity of the n-type silicon layer or the p-type silicon layer can be enhanced without changing quality of the i-type silicon layer, and the photovoltaic conversion efficiency of a solar cell can be improved.

Furthermore, the grain sizes in the direction of the thickness of the i-type silicon layer are large, inhibiting recombination of carriers, due to formation of the oxide film as an underlying film for the i-type silicon layer, and the photovoltaic conversion efficiency of a solar cell can be improved.

### BRIEF DESCRIPTION OF THE SEVERAL VIEWS OF THE DRAWINGS

Fig. 1 is a cross-sectional schematic view showing the structure of a solar cell according to Examples 1 and 2.
Fig. 2 is a cross-sectional schematic view showing a transmission electron microscopic (TEM) image of polycrystalline silicon layers in a solar cell according to Example 2.
Fig. 3 is a graph showing the relation between the short-circuit current densities and the temperatures of thermal annealing in oxidation atmosphere for solar cells according to Example 2, in which the vertical axis represents the relative value of the short-circuit current density according to Example 2 with respect to that of Comparative Example 1, and the horizontal axis represents the temperature of thermal annealing in oxidation atmosphere.
Fig. 4 is a graph showing the relation between the open-circuit voltages and the temperatures of thermal annealing in oxidation atmosphere for solar cells according to Example 2, in which the vertical axis represents the relative value of the open-circuit voltage according to Example 2 with respect to that of Comparative Example 1, and the horizontal axis represents the temperature of thermal annealing in oxidation atmosphere.
Fig. 5 is a graph showing the relation between the fill factors and the temperatures of thermal annealing in oxidation atmosphere for solar cells according to Example 2, in which the vertical axis represents the relative value of the fill factor according to Example 2 with respect to that of Comparative Example 1, and the horizontal axis represents the temperature of thermal annealing in oxidation atmosphere.
Fig. 6 is a graph showing the relation between the photovoltaic conversion efficiencies and the temperatures of thermal annealing in oxidation atmosphere for solar cells according to Example 2, in which the vertical axis represents the relative value of the photovoltaic conversion efficiency according to Example 2 with respect to that of Comparative Example 1, and the horizontal axis represents the temperature of thermal annealing in oxidation atmosphere.
Fig. 7 is a graph showing the relation between the short-circuit current densities and the pressure of the oxygen atmosphere during thermal annealing for solar cells according to Example 2, in which the vertical axis represents the relative value of the short-circuit current density according to Example 2 with respect to that of Comparative Example 1, and the horizontal axis represents the pressure of the oxygen atmosphere during thermal annealing.
Fig. 8 is a graph showing the relation between the open-circuit voltages and the pressure of the oxygen atmosphere during thermal annealing for solar cells according to Example 2, in which the vertical axis represents the relative value of the open-circuit voltage according to Example 2 with respect to that of Comparative Example 1, and the horizontal axis represents the pressure of the oxygen atmosphere during thermal annealing.
Fig. 9 is a graph showing the relation between the fill factors and the pressure of the oxygen atmosphere during thermal annealing for solar cells according to Example 2, in which the vertical axis represents the relative value of the fill factor according to Example 2 with respect to that of Comparative Example 1, and the horizontal axis represents the pressure of the oxygen atmosphere during thermal annealing.
Fig. 10 is a graph showing the relation between the photovoltaic conversion efficiencies and the pressure of the oxygen atmosphere during thermal annealing for solar cells according to Example 2, in which the vertical axis represents the relative value of the photovoltaic conversion efficiency according to Example 2 with respect to that of Comparative Example 1, and the horizontal axis represents the pressure of the oxygen atmosphere during thermal annealing.
Fig. 11 is a cross-sectional schematic view showing the structure of a solar cell according to Example 3.
Fig. 12 is a cross-sectional schematic view showing the structure of a solar cell according to Example 4.
Fig. 13 is a cross-sectional schematic view showing the structure of a solar cell according to Example 5.
Fig. 14 is a cross-sectional schematic view showing the structure of a solar cell according to Example 6.
Fig. 15 is a cross-sectional schematic view showing the structure of a solar cell according to Example 7.
Fig. 16 is a cross-sectional schematic view showing the structure of a solar cell according to Example 8.
Fig. 17 is a cross-sectional schematic view showing the structure of a solar cell according to Example 9.
Fig. 18 is a cross-sectional schematic view showing the structure of a solar cell according to Example 10.
Fig. 19 is a cross-sectional schematic view showing the structure of a solar cell according to Example 11.
Fig. 20 is a cross-sectional schematic view showing the structure of a solar cell according to Example 12.
Fig. 21 is a cross-sectional schematic view showing the structure of a solar cell according to Example 13.

### DETAILED DESCRIPTION OF THE INVENTION

### FIRST EMBODIMENT

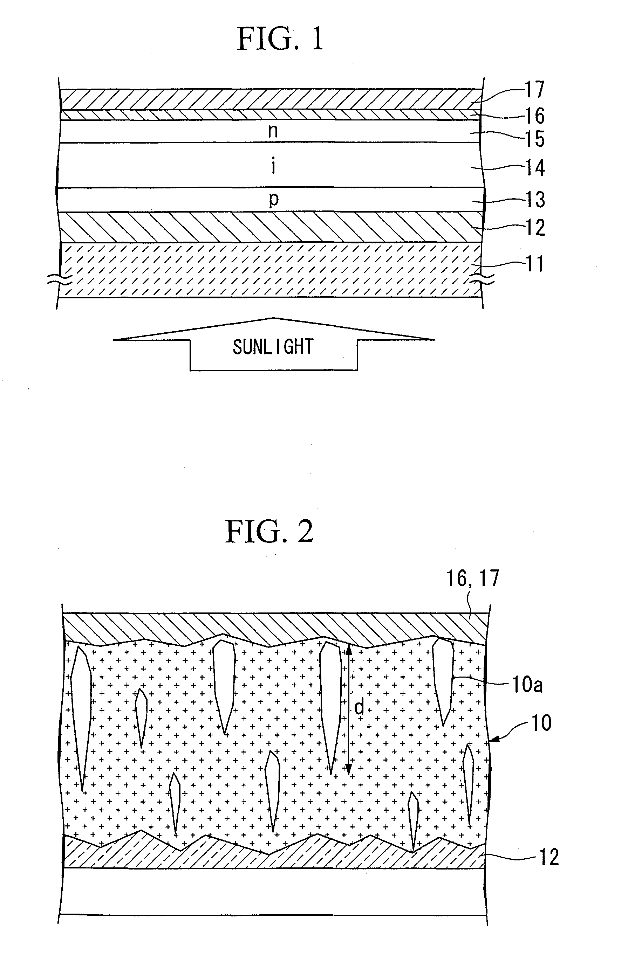

A process according to the present invention for producing the type of solar cell into which light enters through the electrically insulating substrate side will be described with reference to Fig. 1.

### First Step

A first transparent electrode (first electrode) 12 is formed on an electrically insulating transparent substrate (electrically insulating substrate) 11. Optically transparent white crown glass, for example, can be used for the electrically insulating transparent substrate 11. The first transparent electrode 12 is made of a metal oxide such as tin oxide (SnO₂) or zinc oxide (ZnO). In order to prevent the first transparent electrode 12 from being reduced by hydrogen used in the production step of polycrystalline silicon layers as explained below, a zinc oxide film with a thickness of several tens of nanometers may be formed on the first transparent electrode 12.

### Second Step

Subsequently, while the electrically insulating transparent substrate 11 on which the first transparent electrode 12 is formed is held as a processing object on an anode of a plasma enhanced CVD apparatus, the processing object is housed in a reaction chamber, which is then evacuated to a vacuum using a vacuum pump. Then, electricity to a heater incorporated in the anode is turned on, and the substrate, the processing object, is heated, for example, to 160°C or higher. SiH₄, H₂, and p-type dopant gas, which are raw material gases, are then introduced into the reaction chamber, and the pressure in the reaction chamber is regulated at a predetermined level. Then, very high frequency electric power is supplied from a (very high frequency) electric power supply to a discharge electrode to generate plasma between the discharge electrode and the processing object, and thereby a polycrystalline p-type silicon layer 13 is formed on the first transparent electrode 12 of the processing object.

As the p-type dopant gas, B₂H₆ or the like may be used.

### Third Step

Subsequently, the electrically insulating transparent substrate 11 over which the p-type silicon layer 13 is formed is transferred to a thermal annealing apparatus. The interior of the thermal annealing apparatus is filled with an inert gas atmosphere such as nitrogen or argon. Thermal annealing is then carried out by heating the electrically insulating transparent substrate 11 over which the p-type silicon layer 13 is formed for 0.5 to 10 minutes at a temperature in the range of not lower than 80°C and not higher than 200°C, preferably in the range of not lower than 100°C and not higher than 150°C.

This thermal annealing activates the dopant such as boron in the p-type silicon layer 13, thereby enhancing the electric conductivity of the p-type silicon layer and increasing the built-in potential.

If the temperature of the thermal annealing is lower than 80°C, it takes a long time to activate the dopant in the p-type silicon layer 13. A temperature of the thermal annealing higher than 200°C is also not preferred since there would be the risk that the interface between the first transparent electrode 12 and the p-type silicon layer 13 would be deteriorated.

The thermal annealing may also be carried out in a vacuum, the pressure lower than 1 Torr.

### Fourth Step

After the p-type silicon layer 13 has undergone the thermal annealing the electrically insulating transparent substrate 11 is housed as a processing object in a reaction chamber of a plasma enhanced CVD apparatus, and the interior of the reaction chamber is evacuated to a vacuum. A mixed gas of SiH₄ and H₂, which are raw material gases, is then introduced into the reaction chamber, and the pressure in the reaction chamber is regulated at a predetermined level. Then, very high frequency electric power with a frequency of 60 MHz or higher is supplied from a (very high frequency) electric power supply to a discharge electrode to generate plasma between the discharge electrode and the processing object, and thereby an i-type silicon layer 14 is formed on the p-type silicon layer 13 of the processing object.

The pressure in the interior of the reaction chamber when plasma is generated in the reaction chamber is preferably in the range of 0.5 to 10 Torr (67 Pa to 1.7 MPa), and more preferably in the range of 1.0 to 6.0 Torr (133 to 800 Pa).

### Fifth Step

After the i-type silicon layer 14 is formed, supply of the raw material gases is cut off, and the interior of the reaction chamber is evacuated to a vacuum. Then, the electrically insulating transparent substrate 11 is housed as a processing object in another reaction chamber which is evacuated to a vacuum. SiH₄, H₂, and n-type dopant gas (such as PH₃), which are raw material gases, are introduced into this reaction chamber, and the pressure in the reaction chamber is regulated at a predetermined level. Then, very high frequency electric power is supplied from a (very high frequency) electric power supply to a discharge electrode to generate plasma between the discharge electrode and the processing object, and thereby an n-type silicon layer 15 is formed on the i-type silicon layer 14. The processing object is then taken out of the plasma enhanced CVD apparatus, and a second transparent electrode (second electrode) 16 and a back electrode 17 are formed in sequence on the n-type silicon layer 15 to obtain a solar cell. This solar cell generates electricity by photovoltaic conversion from incident light, such as sunlight, from the electrically insulating transparent substrate 11 side in the polycrystalline silicon layers of the PIN structure.

As the n-type dopant gas, PH₃ or the like may be used. The second transparent electrode 16 may be made, for example, from indium tin oxide (ITO) or zinc oxide (ZnO). The back electrode 17 may be made, for example, from Al or Ag.

In the production of the solar cell, a PIN structure is constructed by forming the p-type silicon layer 13, the i-type silicon layer 14, and the n-type silicon layer 15 in sequence from the first transparent electrode 12 side; however, an NIP structure may also be constructed by forming n-type, i-type, and p-type silicon layers in sequence. In such a case, it is preferred that thermal annealing be carried out after deposition of the n-type silicon layer and before deposition of the i-type silicon layer.

Between the first transparent electrode 12 and the polycrystalline silicon layers in a PIN or NIP structure, amorphous silicon layers in a PIN or NIP structure in which the arrangement of p-, i-, and n-type silicon layers is the same as that in the polycrystalline silicon layers may be provided. In such a case, it is preferred that thermal annealing be carried out after the amorphous silicon layers in a PIN or NIP structure and then the p-type or n-type silicon layer are formed.

Moreover, between the first transparent electrode 12 and the polycrystalline silicon layers in a PIN or NIP structure, amorphous silicon layers in a PIN or NIP structure in which the arrangement of p-, i-, and n-type silicon layers is the same as that in the polycrystalline silicon layers may be provided, and in addition, between the second transparent electrode 16 and the polycrystalline silicon layers in a PIN or NIP structure, other polycrystalline silicon layers in a PIN or NIP structure in which the arrangement of p-, i-, and n-type silicon layers is the same as that in the above-described polycrystalline silicon layers may be provided. In such a case, it is preferred that thermal annealing be carried out after the p-type or n-type polycrystalline silicon layer is formed, and another thermal annealing be carried out after the p-type or n-type silicon layer, whichever is formed first in the aforesaid other polycrystalline silicon layers, is formed.

As explained above, according to this embodiment, in which thermal annealing is carried out on the p-type or the n-type silicon layer after the p-type silicon layer or the n-type silicon layer is formed on the first transparent electrode 12, the dopant in this p-type silicon layer or n-type silicon layer is activated so that the electric conductivity of the p-type silicon layer or the n-type silicon layer can be enhanced, and a solar cell which provides excellent photovoltaic conversion efficiency can be produced.

Furthermore, since thermal annealing is carried out before the i-type silicon layer 14 is deposited, the dopant in the p-type silicon layer or n-type silicon layer on the first electrode 12 does not diffuse into the i-type silicon layer 14, and the quality of the i-type silicon layer 14 is not degraded.

Moreover, the thermal annealing carried out at a temperature in the range of not lower than 80°C and not higher than 200°C allows production of a solar cell which provides excellent photovoltaic conversion performance.

### SECOND EMBODIMENT

Next, a process for producing a solar cell will be described as a second embodiment of the present invention. The process for producing a solar cell according to the second embodiment differs from that according to the first embodiment explained above in that thermal annealing of the p-type or n-type silicon layer after formation of the first transparent electrode is carried out in a low-pressure oxygen atmosphere. Therefore, the step of thermal annealing in oxidation atmosphere of the p-type or n-type silicon layer will be described in detail for the second embodiment, whereas detailed description of the other steps, which are similar to those in the first embodiment, will be omitted.

In the first step, a first transparent electrode (first electrode) is formed on an electrically insulating transparent substrate (electrically insulating substrate). Then, in the second step, a polycrystalline p-type silicon layer is formed on the first transparent electrode using a plasma enhanced CVD apparatus.

Then, in the third step, the electrically insulating transparent substrate over which the p-type silicon layer is formed is transferred to a thermal annealing apparatus, the interior of which is provided with a low-pressure oxygen atmosphere of about 0.1 to 760 Torr (13 Pa to 0.1 MPa). Thermal annealing is then carried out by heating the electrically insulating transparent substrate over which the p-type silicon layer is formed for 0.5 to 10 minutes at a temperature in the range of not lower than 80°C and not higher than 200°C, preferably in the range of not lower than 100°C and not higher than 150°C.

This thermal annealing activates the dopant such as boron in the p-type silicon layer, thereby enhancing the electric conductivity of the p-type silicon layer, and oxidizes the surface of the p-type silicon layer to form an ultrathin silicon oxide layer (oxide film). As explained below, deposition of an i-type silicon layer on the silicon oxide layer reduces the amount of crystal nucleation in the i-type silicon layer and controls formation of microcrystalline grains in the i-type silicon layer.

A pressure of the oxygen gas lower than 0.1 Torr (13 Pa) is not preferred since counterbalancing effects could not be obtained. A pressure of the oxygen gas higher than 760 Torr (0.1 MPa) is not preferred since a thick oxide film would be formed on the p-type silicon layer, working as a high electric resistance interposed in series between the p-type silicon layer and the i-type silicon layer, creating the risk of reduction in photovoltaic conversion efficiency.

If the temperature of the thermal annealing is lower than 80°C, it takes a long time to activate the dopant in the p-type silicon layer, causing a decrease in productivity. A temperature of the thermal annealing higher than 200°C is also not preferred since there would be the risk that the oxide film would become too thick and the interface between the first transparent electrode and the p-type silicon layer would be deteriorated.

Then, in the fourth step after the p-type silicon layer 13 has undergone the thermal annealing, the electrically insulating transparent substrate is housed again as a processing object in a reaction chamber of another plasma enhanced CVD apparatus, and the interior of the reaction chamber is evacuated to a vacuum. A mixed gas of SiH₄ and H₂, which are raw material gases, is then introduced into the reaction chamber, and the pressure in the reaction chamber is regulated at a predetermined level. Then, very high frequency electric power with a frequency of 60 MHz or higher is supplied from a (very high frequency) electric power supply to a discharge electrode to generate plasma between the discharge electrode and the processing object, and thereby an i-type silicon layer is formed on the p-type silicon layer of the processing object.

The above-described thermal annealing forms an ultrathin silicon oxide layer on the p-type silicon layer. Accordingly, the i-type silicon layer is formed on the silicon oxide layer. Growth of the i-type silicon layer on the oxide silicon layer results in a suitably restricted amount of crystal nucleation in the i-type silicon layer. Since the amount of crystal nuclei is reduced, competitive growth conflicts of crystal grains are relaxed, the number of crystal grains in the i-type silicon layer is reduced, and the size of each crystal grain becomes relatively large. Accordingly, growth of the crystal grains in the direction of the thickness of the polycrystalline silicon layers is promoted, the number of grain boundaries which extend in the direction intersecting the direction of the thickness of the Si layers is reduced whereby the number of defects is reduced, and recombination of carriers in the i-type silicon layer is suppressed.

The pressure in the interior of the reaction chamber when plasma is generated in the reaction chamber is preferably in the range of 0.5 to 10 Torr (67 Pa to 1.7 MPa), and more preferably in the range of 1.0 to 6.0 Torr (133 to 800 Pa).

Then, in the fifth step, an n-type silicon layer is formed on the i-type silicon layer using a plasma enhanced CVD apparatus. The processing object is then taken out of the plasma enhanced CVD apparatus, and a second transparent electrode and a back electrode are formed in sequence on the n-type silicon layer to obtain a solar cell. This solar cell generates electricity by photovoltaic conversion from incident light, such as sunlight, from the electrically insulating transparent substrate side in the polycrystalline silicon layers of the PIN structure.

In this embodiment, a PIN structure is constructed by forming the p-type silicon layer, the i-type silicon layer, and the n-type silicon layer in sequence from the first transparent electrode side; however, an NIP structure may also be constructed by forming n-type, i-type, and p-type silicon layers in sequence. In such a case, it is preferred that thermal annealing be carried out after deposition of the n-type silicon layer and before deposition of the i-type silicon layer.

Between the first transparent electrode and the polycrystalline silicon layers in a PIN or NIP structure, amorphous silicon layers in a PIN or NIP structure in which the arrangement of p-, i-, and n-type silicon layers is the same as that in the polycrystalline silicon layers may be provided. In such a case, it is preferred that thermal annealing be carried out after the amorphous silicon layers in a PIN or NIP structure and then the p-type or n-type silicon layer are formed.

Moreover, between the first transparent electrode and the polycrystalline silicon layers in a PIN or NIP structure, amorphous silicon layers in a PIN or NIP structure in which the arrangement of p-, i-, and n-type silicon layers is the same as that in the polycrystalline silicon layers may be provided, and in addition, between the second transparent electrode 16 and the polycrystalline silicon layers in a PIN or NIP structure, other polycrystalline silicon layers in a PIN or NIP structure in which the arrangement of p-, i-, and n-type silicon layers is the same as that in the above-described polycrystalline silicon layers may be provided. In such a case, it is preferred that thermal annealing be carried out after the p-type or n-type polycrystalline silicon layer is formed, and another thermal annealing be carried out after the p-type or n-type silicon layer, whichever is formed first in the aforesaid other polycrystalline silicon layers, is formed.

In addition to the effects similar to those of the first embodiments, the process for producing a solar cell according to the second embodiment has the following effects.

That is, by the process for producing a solar cell according to the second embodiment, the thermal annealing in the low-pressure oxygen atmosphere forms the ultrathin silicon oxide layer on the p-type or n-type silicon layer which is formed on the first electrode, and the i-type silicon layer is formed on this silicon oxide layer; therefore, crystal nucleation in the i-type silicon layer is suitably inhibited, the possibility that growth of crystal grain conflicts each other is reduced, and the crystal growth in the direction of the thickness of the polycrystalline silicon layers is promoted, and thereby the number of grain boundaries which extend in the direction intersecting the direction of the thickness of the polycrystalline silicon layers is reduced. Accordingly, recombination of carriers in the i-type silicon layer is inhibited, and cell performance is improved.

### THIRD EMBODIMENT

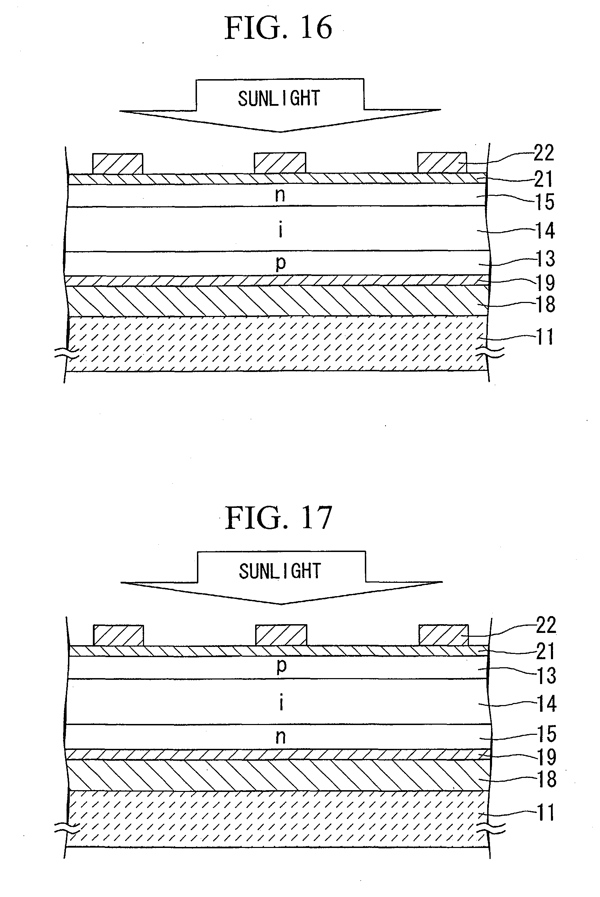

A process according to the present invention for producing the type of solar cell into which light enters through the second transparent electrode side will be described with reference to Fig. 16.

### First Step

A back electrode 18 made, for example, of Al or Ag is formed on a electrically insulating transparent substrate 11 (electrically insulating substrate) made, for example, of optically transparent white crown glass. Then, a first transparent electrode 19 made of a metal oxide such as zinc oxide (ZnO) or indium tin oxide (ITO) is formed on the back electrode 18.

### Second Step

Subsequently, while the electrically insulating transparent substrate 11 on which the first transparent electrode 19 is formed is held as a processing object on an anode of a plasma enhanced CVD apparatus, the processing object is housed in a reaction chamber, which is then evacuated to a vacuum using a vacuum pump. Then, electricity to a heater incorporated in the anode is turned on, and the substrate, the processing object, is heated, for example, to 160°C or higher. SiH₄, H₂, and p-type dopant gas, which are raw material gases, are then introduced into the reaction chamber, and the pressure in the reaction chamber is regulated at a predetermined level. Then, very high frequency electric power is supplied from a (very high frequency) electric power supply to a discharge electrode to generate plasma between the discharge electrode and the processing object, and thereby a polycrystalline p-type silicon layer 13 is formed on the first transparent electrode 19 of the processing object.

As the p-type dopant gas, B₂H₆ or the like may be used.

### Third Step

Subsequently, the electrically insulating transparent substrate 11 over which the p-type silicon layer 13 is formed is transferred to a thermal annealing apparatus. The interior of the thermal annealing apparatus is filled with an inert gas atmosphere, such as nitrogen or argon, or with a vacuum of 1 Torr (133 Pa) or less. Even when a vacuum is employed, it is preferred that the back pressure gas be an inert gas. Thermal annealing is then carried out by heating the electrically insulating transparent substrate 11 over which the p-type silicon layer 13 is formed for 0.5 to 10 minutes at a temperature in the range of not lower than 80°C and not higher than 200°C, preferably in the range of not lower than 100°C and not higher than 150°C.

This thermal annealing activates the dopant such as boron in the p-type silicon layer 13, thereby enhancing the electric conductivity of the p-type silicon layer and increasing the built-in potential.

If the temperature of thermal annealing is lower than 80°C, it takes a long time to activate the dopant in the p-type silicon layer 13, and the productivity is decreased. A temperature of thermal annealing exceeding 200°C is not preferable since counterbalancing effects could not be obtained.

The pressure for the vacuum, when employed, is 1 Torr (133 Pa) or lower in order to prevent degradation in reproducibility due to residual gas contents such as oxygen and moisture.

### Fourth Step

After the p-type silicon layer 13 has undergone the thermal annealing, the electrically insulating transparent substrate 11 is housed as a processing object in a reaction chamber of a plasma enhanced CVD apparatus, and the interior of the reaction chamber is evacuated to a vacuum. A mixed gas of SiH₄ and H₂, which are raw material gases, is then introduced into the reaction chamber, and the pressure in the reaction chamber is regulated at a predetermined level. Then, very high frequency electric power with a frequency of 60 MHz or higher is supplied from a (very high frequency) electric power supply to a discharge electrode to generate plasma between the discharge electrode and the processing object, and thereby an i-type silicon layer 14 is formed on the p-type silicon layer 13 of the processing object.

The pressure in the interior of the reaction chamber when plasma is generated in the reaction chamber is preferably in the range of 0.5 to 10 Torr (67 Pa to 1.7 MPa), and more preferably in the range of 1.0 to 6.0 Torr (133 to 800 Pa).

### Fifth Step

After the i-type silicon layer 14 is formed, introduction of the raw material gases is ceased, and the interior of the reaction chamber is evacuated to a vacuum. Then, the electrically insulating transparent substrate 11 is housed as a processing object in another reaction chamber which is evacuated to a vacuum. SiH₄, H₂, and n-type dopant gas (such as PH₃), which are raw material gases, are introduced into this reaction chamber, and the pressure in the reaction chamber is regulated at a predetermined level. Then, very high frequency electric power is supplied from a (very high frequency) electric power supply to a discharge electrode to generate plasma between the discharge electrode and the processing object, and thereby an n-type silicon layer 15 is formed on the i-type silicon layer 14. The processing object is then taken out of the plasma enhanced CVD apparatus, and a second transparent electrode 21 which is made, for example, of zinc oxide or indium tin oxide (ITO) is formed on the n-type silicon layer 15, and then, a collecting electrode 22 is formed to obtain a solar cell. This solar cell generates electricity by photovoltaic conversion from incident light, such as sunlight, from the second transparent electrode side in the polycrystalline silicon layers of the PIN structure.

In the production of the solar cell, a PIN structure is constructed by forming the p-type silicon layer 13, the i-type silicon layer 14, and the n-type silicon layer 15 in sequence from the first transparent electrode side; however, an NIP structure may also be constructed by forming n-type, i-type, and p-type silicon layers in sequence. In such a case, it is preferred that thermal annealing be carried out after deposition of the n-type silicon layer and before deposition of the i-type silicon layer.

Between the second transparent electrode 21 and the polycrystalline silicon layers in a PIN or NIP structure, amorphous silicon layers in a PIN or NIP structure in which the arrangement of p-, i-, and n-type silicon layers is the same as that in the above-described polycrystalline silicon layers may be provided. In such a case, it is preferred that thermal annealing be carried out after the amorphous silicon layers in a PIN or NIP structure and then the p-type or n-type silicon layer are formed.

In addition, it is possible to form on the first transparent electrode 19 polycrystalline silicon layers in a PIN or NIP structure, then deposit thereon other polycrystalline silicon layers in a PIN or NIP structure in which the arrangement of p-, i-, and n-type silicon layers is the same as that in the aforesaid polycrystalline silicon layers, and then further deposit amorphous silicon layers in a PIN or NIP structure in which the arrangement of p-, i-, and n-type silicon layers is the same as that in the aforesaid polycrystalline silicon layers. In this case, it is preferred that thermal annealing be carried out after the p-type or n-type polycrystalline silicon layer is formed on the first transparent electrode, and another thermal annealing be carried out after the p-type or n-type silicon layer, whichever is formed first in the aforesaid other polycrystalline silicon layers, is formed.

The process for producing a solar cell according to the third embodiment has the effects similar to those of the first embodiment.

### FOURTH EMBODIMENT

Next, a process for producing a solar cell will be described as a fourth embodiment of the present invention. The process for producing a solar cell according to the fourth embodiment differs from that according to the third embodiment explained above in that thermal annealing of the p-type or n-type silicon layer after formation of the first transparent electrode is carried out in a low-pressure oxygen atmosphere. Therefore, the step of thermal annealing of the p-type or n-type silicon layer will be described in detail for the fourth embodiment, whereas detailed description of the other steps, which are similar to those in the third embodiment, will be omitted.

In the first step, a back electrode and a first transparent electrode (first electrode) are formed on an electrically insulating transparent substrate (electrically insulating substrate). Then, in the second step, a polycrystalline p-type silicon layer is formed on the first transparent electrode using a plasma enhanced CVD apparatus.

Then, in the third step, the electrically insulating transparent substrate over which the p-type silicon layer is formed is transferred to a thermal annealing apparatus, the interior of which is provided with a low-pressure oxygen atmosphere of about 0.1 to 760 Torr (13 Pa to 0.1 MPa). Thermal annealing (oxidation) is then carried out by heating the electrically insulating transparent substrate over which the p-type silicon layer is formed for 0.5 to 10 minutes at a temperature in the range of not lower than 80°C and not higher than 200°C, preferably in the range of not lower than 100°C and not higher than 150°C.

This thermal annealing in oxidation atmosphere activates the dopant such as boron in the p-type silicon layer, thereby enhancing the electric conductivity of the p-type silicon layer, and oxidizes the surface of the p-type silicon layer to form an ultrathin silicon oxide layer. As explained below, deposition of an i-type silicon layer on the silicon oxide layer appropriately controls the amount of crystal nucleation in the i-type silicon layer and increases the sizes of grains in the i-type silicon layer.

A pressure of the oxygen gas lower than 0.1 Torr (13 Pa) is not preferred since counterbalancing effects could not be obtained. A pressure of the oxygen gas higher than 760 Torr (0.1 MPa) is not preferred since a thick oxide film would be formed on the p-type silicon layer, working as a high electric resistance interposed in series between the p-type silicon layer and the i-type silicon layer, creating the risk of reduction in photovoltaic conversion efficiency.

If the temperature of the thermal annealing in oxidation atmosphere is lower than 80°C, it takes a long time to activate the dopant in the p-type silicon layer, causing a decrease in productivity. A temperature of the thermal annealing in oxidation atmosphere higher than 200°C is also not preferred since there would be the risk that the oxide film would become too thick and the interface between the first transparent electrode and the p-type silicon layer would be deteriorated.

Then, in the fourth step after the p-type silicon layer 13 has undergone the thermal annealing in oxidation atmosphere, the electrically insulating transparent substrate is housed again as a processing object in a reaction chamber of another plasma enhanced CVD apparatus, and the interior of the reaction chamber is evacuated to a vacuum. A mixed gas of SiH₄ and H₂, which are raw material gases, is then introduced into the reaction chamber, and the pressure in the reaction chamber is regulated at a predetermined level. Then, very high frequency electric power with a frequency of 60 MHz or higher is supplied from a (very high frequency) electric power supply to a discharge electrode to generate plasma between the discharge electrode and the processing object, and thereby an i-type silicon layer is formed on the p-type silicon layer of the processing object.

The above-described thermal annealing in oxidation atmosphere forms an ultrathin silicon oxide layer on the p-type silicon layer. Accordingly, the i-type silicon layer grows on the silicon oxide layer. Growth of the i-type silicon layer on the oxide silicon layer results in reduction in the amount of crystal nucleation in the i-type silicon layer. When the amount of crystal nuclei produced is reduced, the number of crystal grains in the i-type silicon layer is reduced, and the size of each crystal grain becomes relatively large. Accordingly, growth of the crystal grains in the direction of the thickness of the polycrystalline silicon layers is promoted, the number of grain boundaries which extend in the direction intersecting the direction of the thickness of the Si layers is reduced whereby the number of defects is reduced, and recombination of carriers in the i-type silicon layer is inhibited.

The pressure in the interior of the reaction chamber when plasma is generated in the reaction chamber is preferably in the range of 0.5 to 10 Torr (67 Pa to 1.7 MPa), and more preferably in the range of 1.0 to 6.0 Torr (133 to 800 Pa).

Then, in the fifth step, an n-type silicon layer is formed on the i-type silicon layer using a plasma enhanced CVD apparatus. The processing object is then taken out of the plasma enhanced CVD apparatus, and a second transparent electrode and a collecting electrode are formed in sequence on the n-type silicon layer to obtain a solar cell. This solar cell generates electricity by photovoltaic conversion from incident light, such as sunlight, from the second transparent electrode side in the polycrystalline silicon layers of the PIN structure.

In this embodiment, a PIN structure is constructed by forming the p-type silicon layer, the i-type silicon layer, and the n-type silicon layer in sequence from the first transparent electrode side; however, an NIP structure may also be constructed by forming n-type, i-type, and p-type silicon layers in sequence. In such a case, it is preferred that thermal annealing in oxidation atmosphere be carried out after deposition of the n-type silicon layer and before deposition of the i-type silicon layer.

Between the first transparent electrode and the polycrystalline silicon layers in a PIN or NIP structure, amorphous silicon layers in a PIN or NIP structure in which the arrangement of p-, i-, and n-type silicon layers is the same as that in the above-described polycrystalline silicon layers may be provided. In such a case, it is preferred that thermal annealing in oxidation atmosphere be carried out after the amorphous silicon layers in a PIN or NIP structure and then the p-type or n-type silicon layer are formed.

In addition, it is possible to form on the first transparent electrode amorphous silicon layers in a PIN or NIP structure, then deposit thereon other polycrystalline silicon layers in a PIN or NIP structure in which the arrangement of p-, i-, and n-type silicon layers is the same as that in the aforesaid polycrystalline silicon layers, and then further deposit polycrystalline silicon layers in a PIN or NIP structure in which the arrangement of p-, i-, and n-type silicon layers is the same as that in the aforesaid polycrystalline silicon layers. In this case, it is preferred that thermal annealing in oxidation atmosphere be carried out after the p-type or n-type polycrystalline silicon layer is formed on the first transparent electrode, and another thermal annealing in oxidation atmosphere be carried out after the p-type or n-type silicon layer, whichever is formed first in the aforesaid other polycrystalline silicon layers, is formed.

The process for producing a solar cell according to the fourth embodiment has the effects similar to those of the first and second embodiments.

Solar cells according to the present invention and their production processes are described in more detail in Examples 1 to 13 below. Examples 1 to 7 show the type of solar cell into which light enters through an electrically insulating transparent substrate side. Examples 8 to 13 show the type of solar cell into which light enters through a second transparent electrode side.

### Example 1

In Example 1, a solar cell which has been subjected to thermal annealing in an inert gas atmosphere, and which has polycrystalline silicon layers in a PIN structure, will be described with reference to Fig. 1.

First, a first transparent electrode 12 made of tin oxide (SnO₂) was formed on an electrically insulating transparent substrate 11 made of optically transparent white crown glass.

Next, the electrically insulating transparent substrate 11 on which the first transparent electrode 12 had been formed was housed as a processing object in a reaction chamber of a plasma enhanced CVD apparatus, and a vacuum was prepared in the reaction chamber by operating a vacuum pump. Then, the processing object was heated to 160°C. After the heated temperature had been well stabilized, SiH₄, H₂, and B₂H₆, which are raw material gases, were introduced into the reaction chamber at flow rates of 3 sccm, 300 sccm, and 0.016 sccm, respectively, and the pressure inside the reaction chamber was controlled to be at 500 mTorr. After the temperature and the pressure had been well stabilized, very high frequency electric power with a frequency of 100 MHz and an output of 75 W was supplied to a discharge electrode to generate plasma between the discharge electrode and the processing object, and thereby a p-type silicon layer 13 with a thickness of 30 nm was formed on the first transparent electrode 12 of the processing object.

Subsequently, the electrically insulating transparent substrate 11 over which the p-type silicon layer 13 had been formed was transferred to a thermal annealing apparatus. The interior of the thermal annealing apparatus was filled with a nitrogen atmosphere at a pressure of 10 Torr. Thermal annealing was then carried out by heating the electrically insulating transparent substrate 11 over which the p-type silicon layer 13 had been formed for 10 minutes at a temperature 200°C.

Then, the electrically insulating transparent substrate 11 over which the p-type silicon layer 13 had been formed and subjected to thermal annealing was housed as a processing object in a reaction chamber of a plasma enhanced CVD apparatus, and a vacuum was prepared in the reaction chamber by operating a vacuum pump. Then, the processing object was heated to 180°C. After the heated temperature had been well stabilized, SiH₄ and H₂, which are raw material gases, were introduced into the reaction chamber at flow rates of 15 sccm and 300 sccm, respectively, and the pressure inside the reaction chamber was controlled to be at 1.0 Torr. After the temperature and the pressure had been well stabilized, very high frequency electric power with a frequency of 100 MHz and an output of 15 W was supplied to a discharge electrode to generate plasma between the discharge electrode and the processing object, and thereby an i-type silicon layer 14 with a thickness of 1500 nm was formed on the p-type silicon layer 13 of the processing object.

Then, a vacuum was prepared in the reaction chamber by operating a vacuum pump. The processing object was then housed in another reaction chamber which was evacuated to a vacuum, and subsequently the processing object was heated to 170°C. After the heated temperature had been well stabilized, SiH₄, H₂, and PH₃, which are raw material gases, were introduced into the reaction chamber at flow rates of 3 sccm, 300 sccm, and 0.1 sccm, respectively, and the pressure inside the reaction chamber was controlled to be at 700 mTorr. After the temperature and the pressure had been well stabilized, very high frequency electric power with a frequency of 60 MHz and an output of 15 W was supplied to a discharge electrode to generate plasma between the discharge electrode and the processing object, and thereby an n-type silicon layer 15 with a thickness of 50 nm was formed on the i-type silicon layer 14 of the processing object.

Subsequently, the processing object was taken out of the reaction chamber of the plasma enhanced CVD apparatus, and a second transparent electrode 16 made of zinc oxide and a back electrode 17 made of Ag were formed in sequence on the n-type silicon layer 15 to obtain a solar cell as shown in Fig. 1.

### Comparative Example 1

A solar cell of Comparative Example 1 was produced in a manner similar to that described in Example 1 except that thermal annealing was not carried out on the p-type silicon layer.

Electric power generation performance of the solar cells according to Example 1 and Comparative Example 1 was evaluated by irradiating the electrically insulating transparent substrate side of each solar cell with solar simulator (spectral type: AM 1.5; irradiation intensity: 1 kW/m²; irradiation temperature: 25°C). The results are shown in Table 1. In Table 1, the short-circuit current density J_{SC}, open-circuit voltage V_{OC}, and fill factor FF of each solar cell are shown as relative values, which are standardized based on the measured values of Comparative Example 1 (i.e., a measured value of Comparative Example 1 is regarded as 1.0).

**Table 1**

| | J_{SC} | V_{OC} | FF | Photovoltaic conversion efficiency |
|---|---|---|---|---|
| Example 1 | 1.07 | 1.06 | 0.976 | 1.12 |
| Comparative Example 1 | 1.00 | 1.00 | 1.00 | 1.00 |

As shown in Table 1, it can be seen that the solar cell according to Example 1 had a greatly increased photovoltaic conversion efficiency in comparison with the solar cell according to Comparative Example 1. Moreover, it can be seen that the short-circuit current density and open-circuit voltage of the solar cell according to Example 1 were also improved. These are because the carriers were activated by thermal annealing of p-type silicon layer 13, which is a part of the solar cell according to Example 1, and the electric conductivity of the p-type silicon layer 13 was improved.

### Example 2

In Example 2, a solar cell which has been subjected to thermal annealing (oxidation) in a low-pressure oxygen atmosphere, and which has polycrystalline silicon layers in a PIN structure, will be described with reference to Fig. 1

First, a first transparent electrode 12 made of tin oxide (SnO₂) was formed on an electrically insulating transparent substrate 11 made of optically transparent white crown glass.

Next, the electrically insulating transparent substrate 11 on which the first transparent electrode 12 had been formed was housed as a processing object in a reaction chamber of a plasma enhanced CVD apparatus, and a vacuum was prepared in the reaction chamber by operating a vacuum pump. Then, the processing object was heated to 160°C. After the heated temperature had been well stabilized, SiH₄, H₂, and B₂H₆, which are raw material gases, were introduced into the reaction chamber at flow rates of 3 sccm, 300 sccm, and 0.016 sccm, respectively, and the pressure inside the reaction chamber was controlled to be at 500 mTorr. After the temperature and the pressure had been well stabilized, very high frequency electric power with a frequency of 100 MHz and an output of 75 W was supplied to a discharge electrode to generate plasma between the discharge electrode and the processing object, and thereby a p-type silicon layer 13 with a thickness of 30 nm was formed on the first transparent electrode 12 of the processing object.

Subsequently, the electrically insulating transparent substrate 11 over which the p-type silicon layer 13 had been formed was transferred to a thermal annealing apparatus. The interior of the thermal annealing apparatus was filled with an oxygen gas at a pressure 1 and 10 Torr. Thermal annealing in oxidation atmosphere was then carried out by heating the electrically insulating transparent substrate 11 over which the p-type silicon layer 13 had been formed for 10 minutes at a temperature 100, 150, 200, and 280°C. Thus, an ultrathin silicon oxide layer was formed on the top surface of the p-type silicon layer 13.

Then, the electrically insulating transparent substrate 11 over which the p-type silicon layer 13 had been formed and subjected to thermal annealing in oxidation atmosphere was housed as a processing object in a reaction chamber of a plasma enhanced CVD apparatus, and a vacuum was prepared in the reaction chamber by operating a vacuum pump. Then, the processing object was heated to 180°C. After the heated temperature had been well stabilized, SiH₄ and H₂, which are raw material gases, were introduced into the reaction chamber at flow rates of 15 sccm and 300 sccm, respectively, and the pressure inside the reaction chamber was controlled to be at 1.0 Torr. After the temperature and the pressure had been well stabilized, very high frequency electric power with a frequency of 100 MHz and an output of 15 W was supplied to a discharge electrode to generate plasma between the discharge electrode and the processing object, and thereby an i-type silicon layer 14 with a thickness of 1500 nm was formed on the p-type silicon layer 13 of the processing object.

Then, a vacuum was prepared in the reaction chamber by operating a vacuum pump. The processing object was then housed in another reaction chamber which was evacuated to a vacuum, and subsequently the processing object was heated to 170°C. After the heated temperature had been well stabilized, SiH₄, H₂, and PH₃, which are raw material gases, were introduced into the reaction chamber at flow rates of 3 sccm, 300 sccm, and 0.1 sccm, respectively, and the pressure inside the reaction chamber was controlled to be at 700 mTorr. After the temperature and the pressure had been well stabilized, very high frequency electric power with a frequency of 100 MHz and an output of 15 W was supplied to a discharge electrode to generate plasma between the discharge electrode and the processing object, and thereby an n-type silicon layer 15 with a thickness of 50 nm was formed on the i-type silicon layer 14 of the processing object.

Subsequently, the processing object was taken out of the reaction chamber of the plasma enhanced CVD apparatus, and a second transparent electrode 16 made of zinc oxide and a back electrode 17 made of Ag were formed in sequence on the n-type silicon layer 15 to obtain a solar cell as shown in Fig. 1.

A cross-section of the polycrystalline silicon layers in a PIN structure of the solar cell which had been subjected to thermal annealing in the low-pressure oxygen gas of 1.0 Torr at 150°C was observed in a transmission electron microscope (TEM). A schematic view of the TEM image is shown in Fig. 2.

As shown in Fig. 2, it can be seen that the polycrystalline silicon layers 10 contained numerous crystal grains 10a that had grown in the direction of the thickness of the layers. The grain sizes d in the longitudinal direction of the crystal grains 10a were between 0.9 to 1.2 µm. On the other hand, observation of the TEM image of the polycrystalline silicon layers of Comparative Example 1 in a similar manner revealed that the grain sizes in the longitudinal direction of the crystal grains were not larger than 0.7 µm. Thus, the grain sizes of the crystal grains in the longitudinal direction of the crystal grains of Example 2 were increased by 20 to 50% with respect to those of Comparative Example 1. As described above, it can be seen that the polycrystalline silicon layers 10 in the solar cell in which the surface of the p-type silicon layer had been subjected to thermal annealing in oxidation atmosphere had numerous crystal grains 10a which had grown in the direction of the thickness of the polycrystalline silicon layers, and that the polycrystalline silicon layers 10 therefore had fewer grain boundaries which extended in the direction intersecting at right angles to the direction of the thickness of the polycrystalline silicon layers, whereby recombination of carriers would be inhibited.

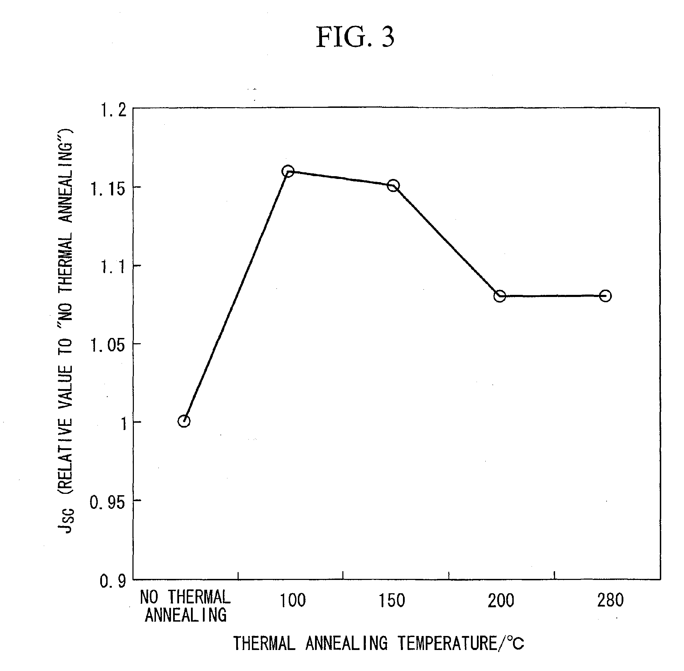

Electric power generation performance of the solar cells according to Example 2 and Comparative Example 1 was then evaluated by irradiating the electrically insulating transparent substrate side of each solar cell with solar simulator (spectral type: AM 1.5; irradiation intensity: 100 mW/cm²; irradiation temperature: 25°C). The results are shown in Figs. 3 to 10.

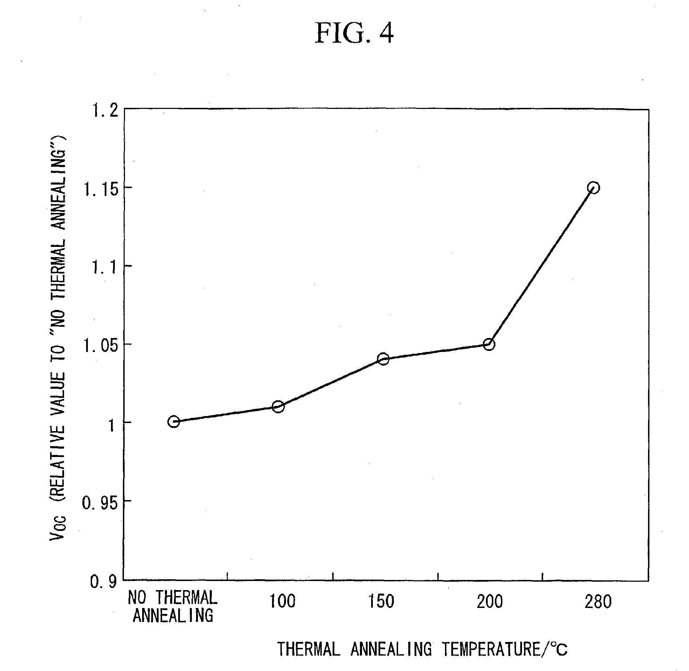

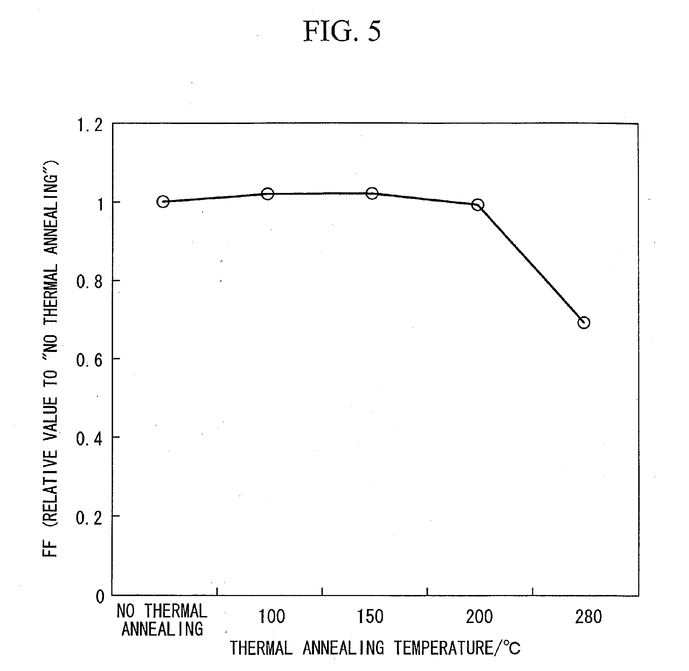

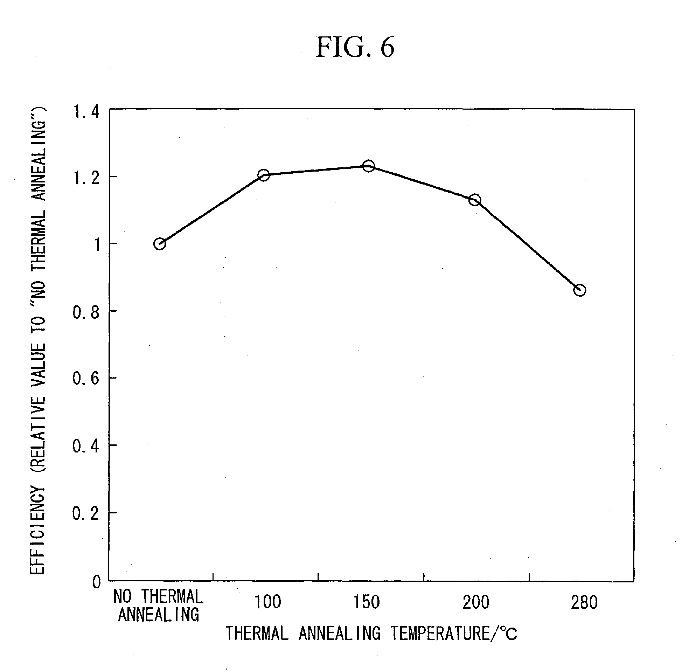

Fig. 3 is a graph showing the relation between the short-circuit current densities and the temperatures of thermal annealing in oxidation atmosphere for solar cells according to Example 2. Fig. 4 is a graph showing the relation between the open-circuit voltages and the temperatures of thermal annealing in oxidation atmosphere for solar cells according to Example 2. Fig. 5 is a graph showing the relation between the fill factors and the temperatures of thermal annealing in oxidation atmosphere for solar cells according to Example 2. Fig. 6 is a graph showing the relation between the photovoltaic conversion efficiencies and the temperatures of thermal annealing in oxidation atmosphere for solar cells according to Example 2. For Figs. 3 to 6, the pressure of oxygen gas for the thermal annealing was 10 Torr.

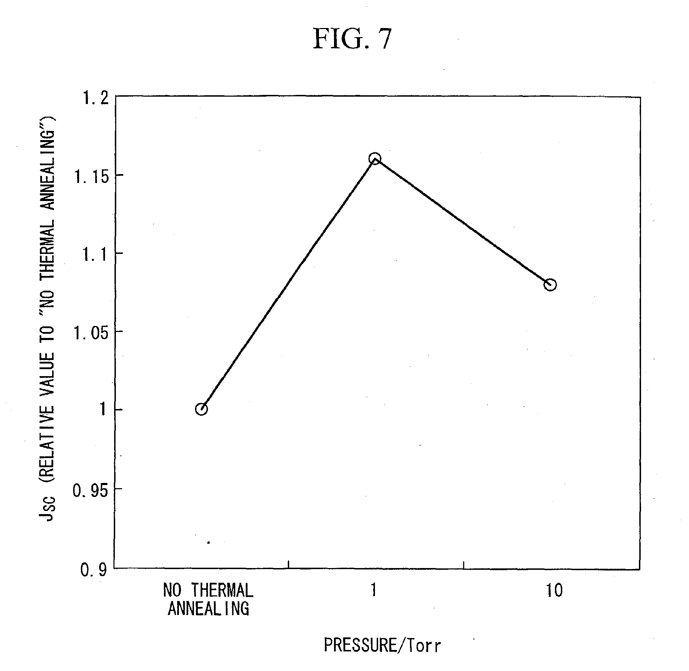

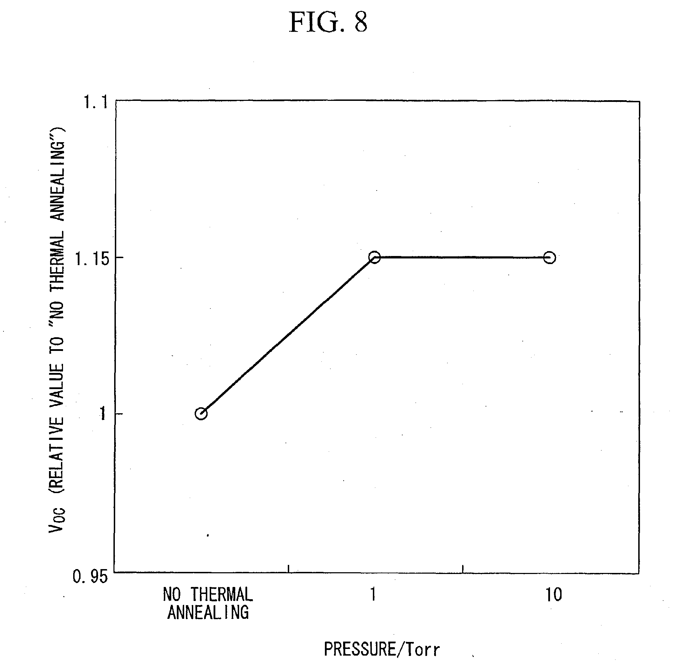

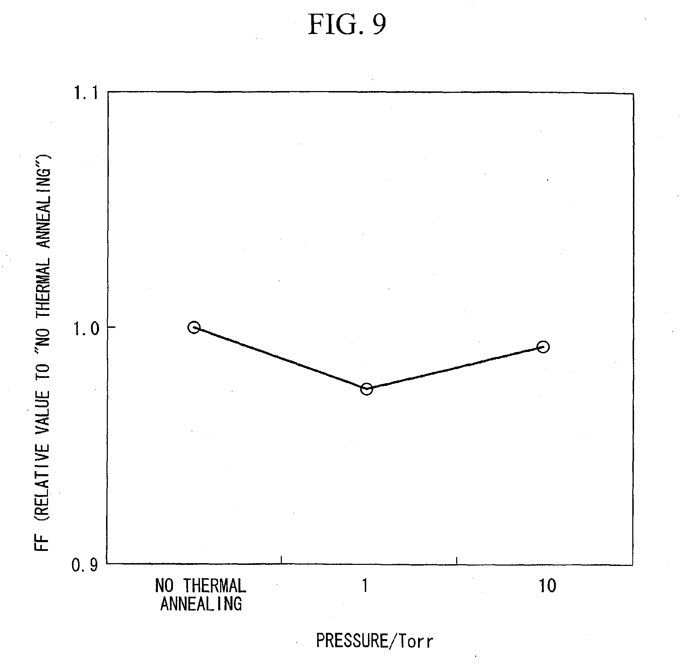

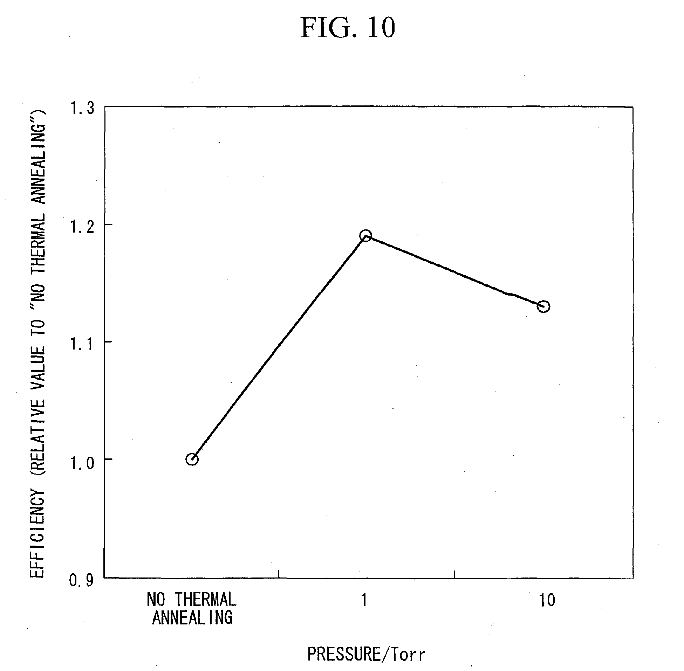

Fig. 7 is a graph showing the relation between the short-circuit current densities and the pressure of the oxygen gas during thermal annealing for solar cells according to Example 2. Fig. 8 is a graph showing the relation between the open-circuit voltages and the pressure of the oxygen gas during thermal annealing for solar cells according to Example 2. Fig. 9 is a graph showing the relation between the fill factors and the pressure of the oxygen gas during thermal annealing for solar cells according to Example 2. Fig. 10 is a graph showing the relation between the photovoltaic conversion efficiencies and the pressure of the oxygen gas during thermal annealing for solar cells according to Example 2. For Figs. 7 to 10, the temperature of the thermal annealing was 200°C.

In Figs. 3 to 10, the short-circuit current density J_{SC}, open-circuit voltage V_{OC}, and fill factor FF of each solar cell are shown as relative values, which are standardized based on the measured values of Comparative Example 1 (i.e., a measured value of Comparative Example 1 is regarded as 1.0).

As shown in Fig. 3, it can be seen that the value of the short-circuit current density J_{SC} is excellent particularly in the case where the thermal annealing temperature in oxidation atmosphere is in the range of 100 to 150°C. In addition, even in the case where the thermal annealing temperature is in the range of 150 to 280°C, it can be seen that the value of the short-circuit current density J_{SC} is superior to that of Comparative Example 1 (in which no thermal annealing in oxidation atmosphere was carried out).

As shown in Fig. 4, it can be seen that the open-circuit voltage is improved as the thermal annealing temperature in oxidation atmosphere increases.

As shown in Fig. 5, it can be seen that the fill factor, in the case where the thermal annealing temperature in oxidation atmosphere is in the range of 100 to 200°C, is the same as that of Comparative Example 1 (in which no thermal annealing in oxidation atmosphere was carried out). In the case where the thermal annealing temperature in oxidation atmosphere is higher than 200°C, it can be seen that the fill factor is smaller than that of Comparative Example 1 (in which no thermal annealing in oxidation atmosphere was carried out).

As shown in Fig. 6, the photovoltaic conversion efficiency, in the case where the thermal annealing temperature in oxidation atmosphere is in the range of 100 to 200°C, is superior to that of Comparative Example 1; however, the photovoltaic conversion efficiency is degraded in the case where the thermal annealing temperature in oxidation atmosphere is higher than 200°C.

As shown in Fig. 7, it can be seen that as the pressure of the oxygen gas during thermal annealing lowers, the value of the short-circuit current density J_{SC} becomes particularly superior.

As shown in Fig. 8, it can be seen that the open-circuit voltage, in the case where the pressure of the oxygen gas during thermal annealing is in the range of 1 to 10 Torr, does not vary, but is clearly improved in comparison with that of Comparative Example 1.

As shown in Fig. 9, it can be seen that the fill factor, in the case where the pressure of the oxygen gas during thermal annealing is in the range of 1 to 10 Torr, is slightly smaller than that of Comparative Example 1.

As shown in Fig. 10, it can be seen that as the pressure of the oxygen gas during thermal annealing lowers, the value of the photovoltaic conversion efficiency becomes particularly superior. However, this does not indicate that a higher pressure of the oxygen atmosphere is always better in view of the duration and temperature of the thermal annealing.

As is clear from the above, a thermal annealing temperature in the range of 100 to 200°C is preferable, and a thermal annealing temperature of 150°C is particularly preferable. In addition, it can be seen that the pressure of the oxygen gas during thermal annealing is effective in the range of 1 to 10 Torr.

Thus, it can be seen that thermal annealing in a low-pressure oxygen atmosphere carried out in the midst of forming polycrystalline silicon layers promotes growth of crystal grains in the direction of the thickness of the layers, reduces the number of grain boundaries which extend in the direction intersecting the direction of the thickness of the layers, and inhibits recombination of carriers, resulting in improvement in the photovoltaic conversion efficiency (= short-circuit current density × open-circuit voltage × fill factor).

### Example 3

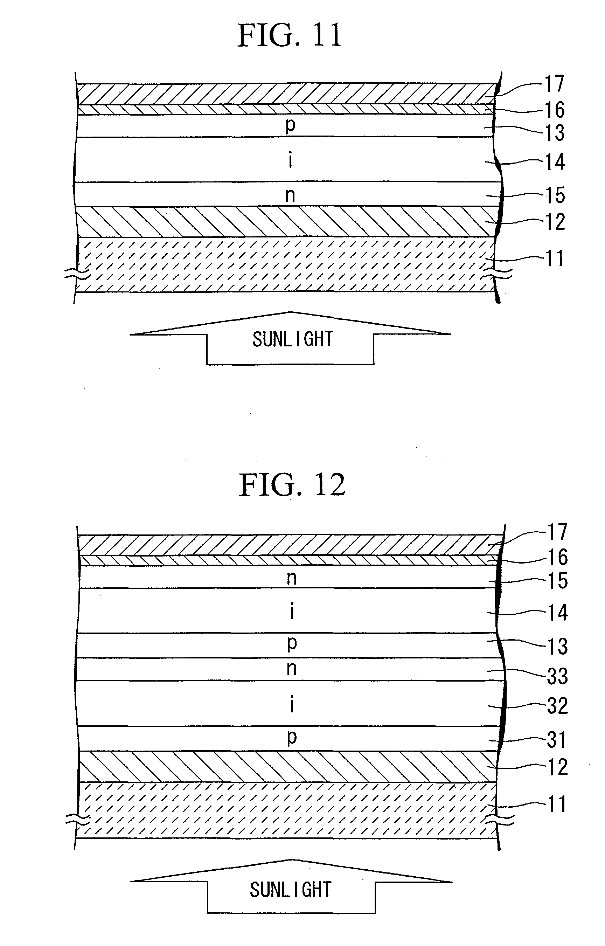

In Example 3, the type of solar cell into which light enters through an electrically insulating transparent substrate side, having polycrystalline silicon layers in an NIP structure and having been subjected to thermal annealing in a decompressed oxygen atmosphere, will be described with reference to Fig. 11.

As shown in Fig. 11, a first transparent electrode 12 made of tin oxide was formed on an electrically insulating transparent substrate 11 made of optically transparent white crown glass. Subsequently, in a manner similar to that of Example 1, an n-type polycrystalline silicon layer 15, an i-type polycrystalline silicon layer 14, and a p-type polycrystalline silicon layer 13 were deposited on the first transparent electrode 12. After the n-type polycrystalline silicon layer 15 was deposited, thermal annealing of the n-type polycrystalline silicon layer 15 was carried out in a decompressed oxygen atmosphere in a manner similar to that in Example 2 to form an ultrathin silicon oxide layer on the top surface of the n-type polycrystalline silicon layer 15. Then, a second transparent electrode 16 made of zinc oxide and a back electrode 17 made of Ag were formed in sequence to obtain a solar cell as shown in Fig. 11.

Electric power generation performance of the solar cell according to Example 3 was evaluated by irradiating the electrically insulating transparent substrate side of the solar cell with solar simulator (spectral type: AM 1.5; irradiation intensity: 100 mW/cm²; irradiation temperature: 25°C). As a result, excellent electric power generation performance which is similar to those of Example 2 was obtained.

### Example 4

In Example 4, the type of tandem solar cell into which light enters through an electrically insulating transparent substrate side, having polycrystalline silicon layers in a PIN structure and amorphous silicon layers in a PIN structure and having been subjected to thermal annealing in a low-pressure oxygen atmosphere, will be described with reference to Fig. 12.

As shown in Fig. 12, a first transparent electrode 12 made of tin oxide was formed on an electrically insulating transparent substrate 11 made of optically transparent white crown glass. Subsequently, amorphous silicon layers in a PIN structure were formed by depositing a p-type silicon layer (amorphous silicon layer) 31, an i-type silicon layer (amorphous silicon layer) 32, and an n-type silicon layer (amorphous silicon layer) 33 on the first transparent electrode 12. The amorphous silicon layers were formed mainly by lowering the dilution ratio of silane to hydrogen. Subsequently, in a manner similar to that of Example 1, a p-type polycrystalline silicon layer 13, an i-type polycrystalline silicon layer 14, and an n-type polycrystalline silicon layer 15 were deposited on the amorphous silicon layers. After the p-type polycrystalline silicon layer 13 was deposited, thermal annealing of the p-type polycrystalline silicon layer 13 was carried out in a low-pressure oxygen atmosphere in a manner similar to that in Example 2 to form an ultrathin silicon oxide layer on the top surface of the p-type polycrystalline silicon layer 13. Then, a second transparent electrode 16 made of zinc oxide and a back electrode 17 made of Ag were formed in sequence to obtain a solar cell as shown in Fig. 12. Electric power generation performance of the solar cell according to Example 4 was evaluated by irradiating the electrically insulating transparent substrate side of the solar cell with solar simulator (spectral type: AM 1.5; irradiation intensity: 100 mW/cm²; irradiation temperature: 25°C). As a result, excellent electric power generation performance which is similar to those of Example 2 was obtained.

### Example 5

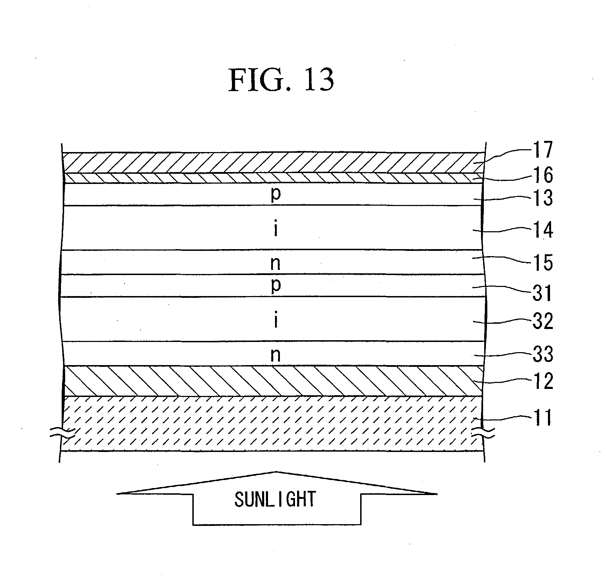

In Example 5, the type of tandem solar cell into which light enters through an electrically insulating transparent substrate side, having polycrystalline silicon layers in an NIP structure and amorphous silicon layers in a NIP structure and having been subjected to thermal annealing in a low-pressure oxygen atmosphere, will be described with reference to Fig. 13.

As shown in Fig. 13, a first transparent electrode 12 made of tin oxide was formed on an electrically insulating transparent substrate 11 made of optically transparent white crown glass. Subsequently, amorphous silicon layers in an NIP structure were formed by depositing an n-type silicon layer (amorphous silicon layer) 33, an i-type silicon layer (amorphous silicon layer) 32, and a p-type silicon layer (amorphous silicon layer) 31 on the first transparent electrode 12. Subsequently, in a manner similar to that of Example 1, an n-type polycrystalline silicon layer 15, an i-type polycrystalline silicon layer 14, and a p-type polycrystalline silicon layer 13 were deposited on the amorphous silicon layers. After the n-type polycrystalline silicon layer 15 was deposited, thermal annealing of the n-type polycrystalline silicon layer 15 was carried out in a low-pressure oxygen atmosphere in a manner similar to that in Example 2 to form an ultrathin silicon oxide layer on the top surface of the n-type polycrystalline silicon layer 15. Then, a second transparent electrode 16 made of zinc oxide and a back electrode 17 made of Ag were formed in sequence to obtain a solar cell as shown in Fig. 13.

Electric power generation performance of the solar cell according to Example 5 was evaluated by irradiating the electrically insulating transparent substrate side of the solar cell with solar simulator (spectral type: AM 1.5; irradiation intensity: 100 mW/cm²; irradiation temperature: 25°C). As a result, excellent electric power generation performance which is similar to those of Example 2 was obtained.

### Example 6

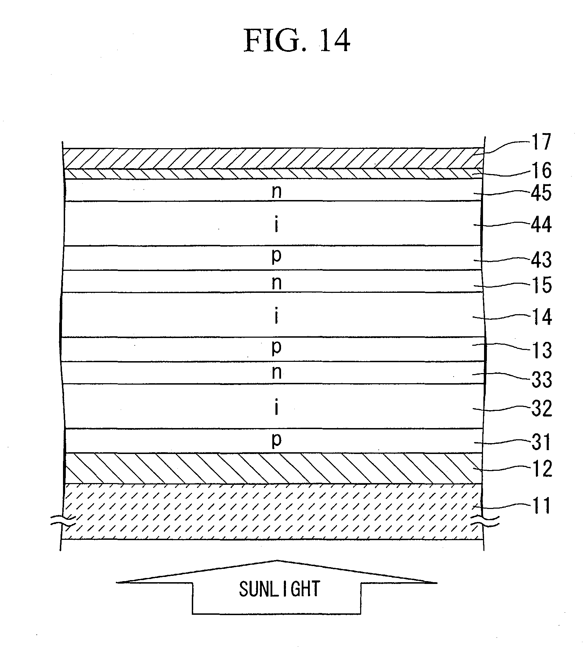

In Example 6, the type of triple solar cell into which light enters through an electrically insulating transparent substrate side, having polycrystalline silicon layers in a PIN structure, other polycrystalline silicon layers in a PIN structure, and amorphous silicon layers in a PIN structure, and having been subjected to thermal annealing in a low-pressure oxygen atmosphere, will be described with reference to Fig. 14.

As shown in Fig. 14, a first transparent electrode 12 made of tin oxide was formed on an electrically insulating transparent substrate 11 made of optically transparent white crown glass. Subsequently, amorphous silicon layers in a PIN structure were formed by depositing a p-type silicon layer (amorphous silicon layer) 31, an i-type silicon layer (amorphous silicon layer) 32, and an n-type silicon layer (amorphous silicon layer) 33 on the first transparent electrode 12.

Subsequently, in a manner similar to that of Example 1, a p-type polycrystalline silicon layer 13, an i-type polycrystalline silicon layer 14, and an n-type polycrystalline silicon layer 15 were deposited on the amorphous silicon layers to form polycrystalline silicon layers in a PIN structure. After the p-type polycrystalline silicon layer 13 was deposited, thermal annealing of the p-type polycrystalline silicon layer 13 was carried out in a low-pressure oxygen atmosphere in a manner similar to that in Example 2 to form an ultrathin silicon oxide layer on the top surface of the p-type polycrystalline silicon layer 13.

Then, in a manner similar to that of Example 1, a p-type polycrystalline silicon layer 43, an i-type polycrystalline silicon layer 44, and an n-type polycrystalline silicon layer 45 were deposited on the aforesaid polycrystalline silicon layers in a PIN structure to form other polycrystalline silicon layers in a PIN structure. After the p-type polycrystalline silicon layer 43 was deposited, thermal annealing of the p-type polycrystalline silicon layer 43 was carried out in a low-pressure oxygen atmosphere in a manner similar to that in Example 2 to further form an ultrathin silicon oxide layer on the top surface of the p-type polycrystalline silicon layer 43.

Then, a second transparent electrode 16 made of zinc oxide and a back electrode 17 made of Ag were formed in sequence to obtain a solar cell as shown in Fig. 14.

Electric power generation performanceof the solar cell according to Example 6 was evaluated by irradiating the electrically insulating transparent substrate side of the solar cell with solar simulator (spectral type: AM 1.5; irradiation intensity: 100 mW/cm²; irradiation temperature: 25°C). As a result, excellent electric power generation performance which is similar to those of Example 2 was obtained.

### Example 7

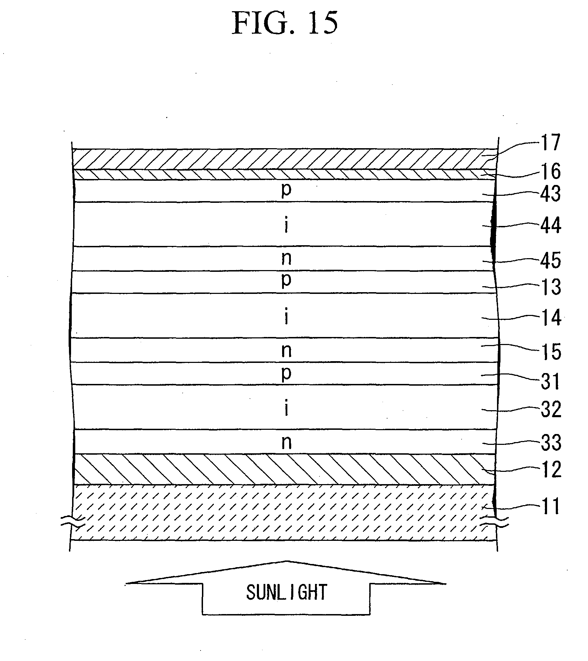

In Example 7, the type of triple solar cell into which light enters through an electrically insulating transparent substrate side, having polycrystalline silicon layers in an NIP structure, other polycrystalline silicon layers in an NIP structure, and amorphous silicon layers in an NIP structure, and having been subjected to thermal annealing in a low-pressure oxygen atmosphere, will be described with reference to Fig. 15.

As shown in Fig. 15, a first transparent electrode 12 made of tin oxide was formed on an electrically insulating transparent substrate 11 made of optically transparent white crown glass. Subsequently, amorphous silicon layers in an NIP structure were formed by depositing an n-type silicon layer (amorphous silicon layer) 33, an i-type silicon layer (amorphous silicon layer) 32, and a p-type silicon layer (amorphous silicon layer) 31 on the first transparent electrode 12.

Subsequently, in a manner similar to that of Example 1, an n-type polycrystalline silicon layer 15, an i-type polycrystalline silicon layer 14, and a p-type polycrystalline silicon layer 13 were deposited on the amorphous silicon layers to form polycrystalline silicon layers in an NIP structure. After the n-type polycrystalline silicon layer 15 was deposited, thermal annealing of the n-type polycrystalline silicon layer 15 was carried out in a low-pressure oxygen atmosphere in a manner similar to that in Example 2 to form an ultrathin silicon oxide layer on the top surface of the n-type polycrystalline silicon layer 15.

Then, in a manner similar to that of Example 1, an n-type polycrystalline silicon layer 45, an i-type polycrystalline silicon layer 44, and a p-type polycrystalline silicon layer 43 were deposited on the aforesaid polycrystalline silicon layers to form other polycrystalline silicon layers in an NIP structure. After the n-type polycrystalline silicon layer 45 was deposited, thermal annealing of the n-type polycrystalline silicon layer 45 was carried out in a low-pressure oxygen atmosphere in a manner similar to that in Example 2 to form an ultrathin silicon oxide layer on the top surface of the n-type polycrystalline silicon layer 45.

Then, a second transparent electrode 16 made of zinc oxide and a back electrode 17 made of Ag were formed in sequence to obtain a solar cell as shown in Fig. 15.

Electric power generation performance of the solar cell according to Example 7 was evaluated by irradiating the electrically insulating transparent substrate side of the solar cell with solar simulator (spectral type: AM 1.5; irradiation intensity: 100 mW/cm²; irradiation temperature: 25°C). As a result, excellent electric power generation performance which is similar to those of Example 2 was obtained.

### Example 8

In Example 8, the type of solar cell into which light enters through a second transparent electrode side, having polycrystalline silicon layers in a PIN structure and having been subjected to thermal annealing in a low-pressure oxygen atmosphere, will be described with reference to Fig. 16.

First, a back electrode 18 made of Al and a first transparent electrode 19 made of zinc oxide (ZnO) were formed on an electrically insulating transparent substrate 11 made of optically transparent white crown glass. Subsequently, in a manner similar to that of Example 1, a p-type polycrystalline silicon layer 13, an i-type polycrystalline silicon layer 14, and an n-type polycrystalline silicon layer 15 were deposited on the first transparent electrode 19. After the p-type polycrystalline silicon layer 13 was deposited, thermal annealing of the p-type polycrystalline silicon layer 13 was carried out in a low-pressure oxygen atmosphere in a manner similar to that in Example 2 to form an ultrathin silicon oxide layer on the top surface of the p-type polycrystalline silicon layer 13. Subsequently, a second transparent electrode 21 made of indium tin oxide (ITO) was formed on the n-type polycrystalline silicon layer 15, and then, a collecting electrode 22 was formed on the second transparent electrode 21, to obtain a solar cell as shown in Fig. 16.

Electric power generation performance of the solar cell according to Example 8 was evaluated by irradiating the second transparent electrode side of the solar cell with solar simulator (spectral type: AM 1.5; irradiation intensity: 100 mW/cm²; irradiation temperature: 25°C). As a result, excellent electric power generation performance which is similar to those of Example 2 was obtained.

### Example 9

In Example 9, the type of solar cell into which light enters through a second transparent electrode side, having polycrystalline silicon layers in an NIP structure and having been subjected to thermal annealing in a low-pressure oxygen atmosphere, will be described with reference to Fig. 17.

First, a back electrode 18 made of Ag and a first transparent electrode 19 made of zinc oxide (ZnO) were formed on an electrically insulating transparent substrate 11 made of optically transparent white crown glass. Subsequently, in a manner similar to that of Example 1, an n-type polycrystalline silicon layer 15, an i-type polycrystalline silicon layer 14, and a p-type polycrystalline silicon layer 13 were deposited on the first transparent electrode 19. After the n-type polycrystalline silicon layer 15 was deposited, thermal annealing of the n-type polycrystalline silicon layer 15 was carried out in a low-pressure oxygen atmosphere in a manner similar to that in Example 2 to form an ultrathin silicon oxide layer on the top surface of the n-type polycrystalline silicon layer 15. Subsequently, a second transparent electrode 21 made of indium tin oxide (ITO) was formed on the p-type polycrystalline silicon layer 13, and then, a collecting electrode 22 was formed on the second transparent electrode 21, to obtain a solar cell as shown in Fig. 17.

Electric power generation performance of the solar cell according to Example 9 was evaluated by irradiating the second transparent electrode side of the solar cell with solar simulator (spectral type: AM 1.5; irradiation intensity: 100 mW/cm²; irradiation temperature: 25°C). As a result, excellent electric power generation performance which is similar to those of Example 2 was obtained.

### Example 10

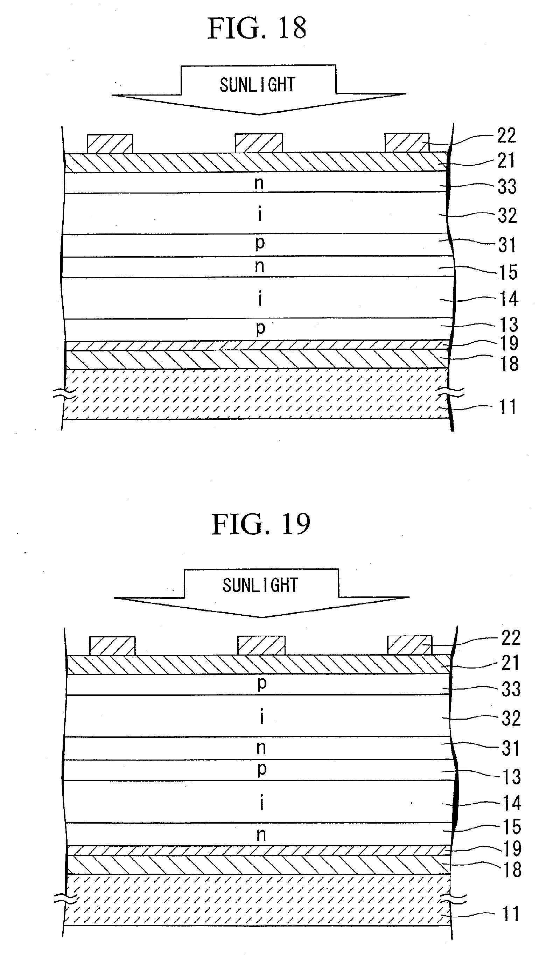

In Example 10, the type of tandem solar cell into which light enters through a second transparent electrode side, having polycrystalline silicon layers in a PIN structure and amorphous silicon layers in a PIN structure and having been subjected to thermal annealing in a low-pressure oxygen atmosphere, will be described with reference to Fig. 18.

First, a back electrode 18 made of Ag and a first transparent electrode 19 made of zinc oxide (ZnO) were formed on an electrically insulating transparent substrate 11 made of optically transparent white crown glass. Subsequently, in a manner similar to that of Example 1, a p-type polycrystalline silicon layer 13, an i-type polycrystalline silicon layer 14, and an n-type polycrystalline silicon layer 15 were deposited on the first transparent electrode 19. After the p-type polycrystalline silicon layer 13 was deposited, thermal annealing of the p-type polycrystalline silicon layer 13 was carried out in a low-pressure oxygen atmosphere in a manner similar to that in Example 2 to form an ultrathin silicon oxide layer on the top surface of the p-type polycrystalline silicon layer 13.

Subsequently, amorphous silicon layers in a PIN structure were formed by depositing a p-type silicon layer (amorphous silicon layer) 31, an i-type silicon layer (amorphous silicon layer) 32, and an n-type silicon layer (amorphous silicon layer) 33 on the n-type polycrystalline silicon layer 15. The amorphous silicon layers were formed mainly by lowering the dilution ratio of silane to hydrogen.

Subsequently, a second transparent electrode 21 made of indium tin oxide (ITO) was formed on the n-type silicon layer 33, and then, a collecting electrode 22 was formed on the second transparent electrode 21, to obtain a solar cell as shown in Fig. 18.

Electric power generation performance of the solar cell according to Example 10 was evaluated by irradiating the second transparent electrode side of the solar cell with solar simulator (spectral type: AM 1.5; irradiation intensity: 100 mW/cm²; irradiation temperature: 25°C). As a result, excellent electric power generation performance which is similar to those of Example 2 was obtained.

### Example 11

In Example 11, the type of tandem solar cell into which light enters through a second transparent electrode side, having polycrystalline silicon layers in an NIP structure and amorphous silicon layers in an NIP structure and having been subjected to thermal annealing in a low-pressure oxygen atmosphere, will be described with reference to Fig. 19.

First, a back electrode 18 made of Ag and a first transparent electrode 19 made of zinc oxide (ZnO) were formed on an electrically insulating transparent substrate 11 made of optically transparent white crown glass. Subsequently, in a manner similar to that of Example 1, an n-type polycrystalline silicon layer 15, an i-type polycrystalline silicon layer 14, and a p-type polycrystalline silicon layer 13 were deposited on the first transparent electrode 19. After the n-type polycrystalline silicon layer 15 was deposited, thermal annealing of the n-type polycrystalline silicon layer 15 was carried out in a low-pressure oxygen atmosphere in a manner similar to that in Example 2 to form an ultrathin silicon oxide layer on the top surface of the n-type polycrystalline silicon layer 15.

Subsequently, amorphous silicon layers in an NIP structure were formed by depositing an n-type silicon layer (amorphous silicon layer) 33, an i-type silicon layer (amorphous silicon layer) 32, and a p-type silicon layer (amorphous silicon layer) 31 on the p-type polycrystalline silicon layer 13. The amorphous silicon layers were formed mainly by lowering the dilution ratio of silane to hydrogen.

Subsequently, a second transparent electrode 21 made of indium tin oxide (ITO) was formed on the p-type silicon layer 31, and then, a collecting electrode 22 was formed on the second transparent electrode 21, to obtain a solar cell as shown in Fig. 19.

Electric power generation performance of the solar cell according to Example 11 was evaluated by irradiating the second transparent electrode side of the solar cell with solar simulator (spectral type: AM 1.5; irradiation intensity: 100 mW/cm²; irradiation temperature: 25°C). As a result, excellent electric power generation performance which is similar to those of Example 2 was obtained.

### Example 12

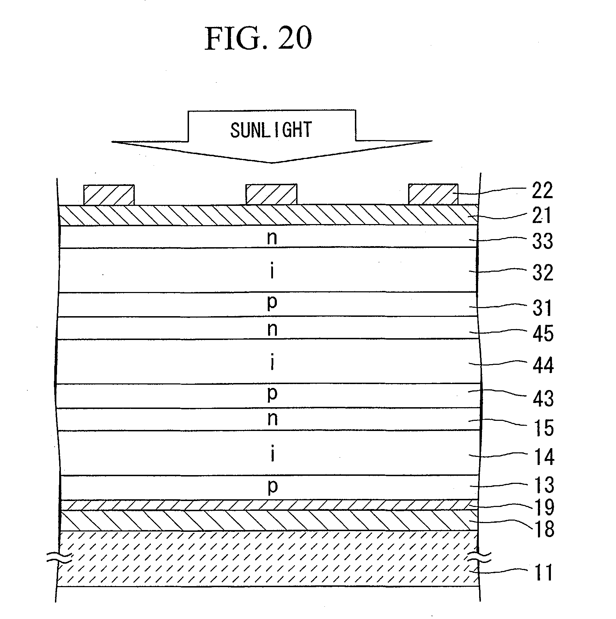

In Example 12, the type of triple solar cell into which light enters through a second transparent electrode side, having polycrystalline silicon layers in a PIN structure, other polycrystalline silicon layers in a PIN structure, and amorphous silicon layers in a PIN structure, and having been subjected to thermal annealing in a low-pressure oxygen atmosphere, will be described with reference to Fig. 20.

First, a back electrode 18 made of Ag and a first transparent electrode 19 made of zinc oxide (ZnO) were formed on an electrically insulating transparent substrate 11 made of optically transparent white crown glass. Subsequently, in a manner similar to that of Example 1, a p-type polycrystalline silicon layer 13, an i-type polycrystalline silicon layer 14, and an n-type polycrystalline silicon layer 15 were deposited on the first transparent electrode 19 to form polycrystalline silicon layers in a PIN structure. After the p-type polycrystalline silicon layer 13 was deposited, thermal annealing of the p-type polycrystalline silicon layer 13 was carried out in a low-pressure oxygen atmosphere in a manner similar to that in Example 2 to form an ultrathin silicon oxide layer on the top surface of the p-type polycrystalline silicon layer 13.

Subsequently, in a manner similar to that of Example 1, a p-type polycrystalline silicon layer 43, an i-type polycrystalline silicon layer 44, and an n-type polycrystalline silicon layer 45 were deposited on the aforesaid polycrystalline silicon layers in a PIN structure to form other polycrystalline silicon layers in a PIN structure. After the p-type polycrystalline silicon layer 43 was deposited, thermal annealing of the p-type polycrystalline silicon layer 43 was carried out in a low-pressure oxygen atmosphere in a manner similar to that in Example 2 to further form an ultrathin silicon oxide layer on the top surface of the p-type polycrystalline silicon layer 43.

Then, amorphous silicon layers in a PIN structure were formed by depositing a p-type silicon layer (amorphous silicon layer) 31, an i-type silicon layer (amorphous silicon layer) 32, and an n-type silicon layer (amorphous silicon layer) 33 on the n-type polycrystalline silicon layer 45.

Subsequently, a second transparent electrode 21 made of indium tin oxide (ITO) was formed on the n-type silicon layer 33, and then, a collecting electrode 22 was formed on the second transparent electrode 21, to obtain a solar cell as shown in Fig. 20.

Electric power generation performance of the solar cell according to Example 12 was evaluated by irradiating the second transparent electrode side of the solar cell with solar simulator (spectral type: AM 1.5; irradiation intensity: 100 mW/cm²; irradiation temperature: 25°C). As a result, excellent electric power generation performance which is similar to those of Example 2 was obtained.

### Example 13

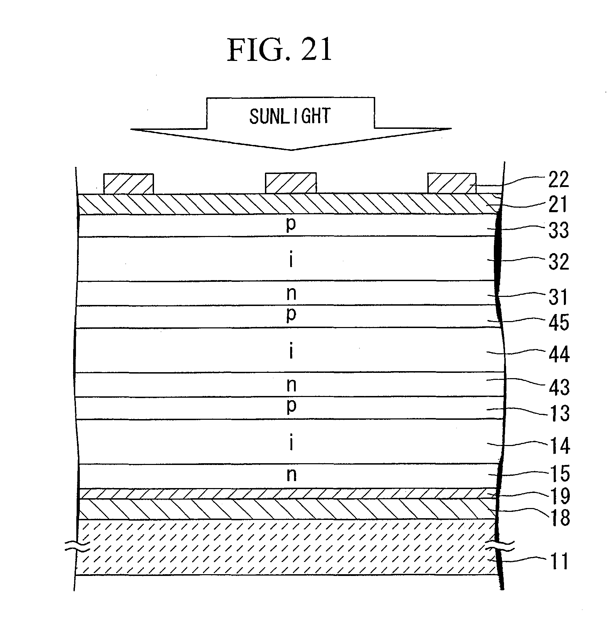

In Example 13, the type of triple solar cell into which light enters through a second transparent electrode side, having polycrystalline silicon layers in an NIP structure, other polycrystalline silicon layers in an NIP structure, and amorphous silicon layers in an NIP structure, and having been subjected to thermal annealing in a low-pressure oxygen atmosphere, will be described with reference to Fig. 21.

First, a back electrode 18 made of Al and a first transparent electrode 19 made of zinc oxide (ZnO) were formed on an electrically insulating transparent substrate 11 made of optically transparent white crown glass. Subsequently, in a manner similar to that of Example 1, an n-type polycrystalline silicon layer 15, an i-type polycrystalline silicon layer 14, and a p-type polycrystalline silicon layer 13 were deposited on the first transparent electrode 19 to form polycrystalline silicon layers in an NIP structure. After the n-type polycrystalline silicon layer 15 was deposited, thermal annealing of the n-type polycrystalline silicon layer 15 was carried out in a low-pressure oxygen atmosphere in a manner similar to that in Example 2 to form an ultrathin silicon oxide layer on the top surface of the n-type polycrystalline silicon layer 15.

Subsequently, in a manner similar to that of Example 1, an n-type polycrystalline silicon layer 45, an i-type polycrystalline silicon layer 44, and a p-type polycrystalline silicon layer 43 were deposited on the aforesaid polycrystalline silicon layers in an NIP structure to form other polycrystalline silicon layers in an NIP structure. After the n-type polycrystalline silicon layer 45 was deposited, thermal annealing of the n-type polycrystalline silicon layer 45 was carried out in a low-pressure oxygen atmosphere in a manner similar to that in Example 2 to form an ultrathin silicon oxide layer on the top surface of the n-type polycrystalline silicon layer 45.

Then, amorphous silicon layers in an NIP structure were formed by depositing an n-type silicon layer (amorphous silicon layer) 33, an i-type silicon layer (amorphous silicon layer) 32, and a p-type silicon layer (amorphous silicon layer) 31 on the p-type polycrystalline silicon layer 43.

Subsequently, a second transparent electrode 21 made of indium tin oxide (ITO) was formed on the p-type silicon layer 31, and then, a collecting electrode 22 was formed on the second transparent electrode 21, to obtain a solar cell as shown in Fig. 21.

Electric power generation performance of the solar cell according to Example 13 was evaluated by irradiating the second transparent electrode side of the solar cell with solar simulator (spectral type: AM 1.5; irradiation intensity: 100 mW/cm²; irradiation temperature: 25°C). As a result, excellent electric power generation performance which is similar to those of Example 2 was obtained.

## Claims

1. A process for producing a solar cell by depositing at least a first electrode, polycrystalline silicon layers in a PIN or NIP structure, and a second electrode in sequence on an electrically insulating substrate, the polycrystalline silicon layers in a PIN or NIP structure including a p-type silicon layer, an i-type silicon layer, and an n-type silicon layer,
wherein the polycrystalline silicon layers in a PIN or NIP structure are formed by: forming a p-type or n-type silicon layer, which is then subjected to thermal annealing; depositing an i-type silicon layer on the p-type or n-type silicon layer; and depositing an n-type or p-type silicon layer on the i-type silicon layer.

2. A process for producing a solar cell according to claim 1, wherein the thermal annealing is carried out in a low-pressure oxygen atmosphere.

3. A process for producing a solar cell according to claim 1, wherein the thermal annealing in oxidation atmosphere is carried out at a temperature not lower than 80°C and not higher than 200°C.

4. A process for producing a solar cell according to claim 1, wherein the thermal annealing in oxidation atmosphere is carried out at a temperature not lower than 100°C and not higher than 150°C.

5. A process for producing a solar cell according to claim 1, comprising forming amorphous silicon layers in a PIN or NIP structure between the first or second electrode and the polycrystalline silicon layers in a PIN or NIP structure so as to form a tandem structure.

6. A process for producing a solar cell according to claim 5, comprising depositing on the polycrystalline silicon layers in a PIN or NIP structure other polycrystalline silicon layers in a PIN or NIP structure so as to form a triple structure.

7. A process for producing a solar cell according to claim 6, wherein said other polycrystalline silicon layers in a PIN or NIP structure are formed by: forming a p-type or n-type silicon layer, which is then subjected to thermal annealing; depositing an i-type silicon layer on the p-type or n-type silicon layer; and depositing an n-type or p-type silicon layer on the i-type silicon layer.

8. A process for producing a solar cell according to claim 6, wherein said other polycrystalline silicon layers in a PIN or NIP structure are formed by: forming a p-type or n-type silicon layer, which is then subjected to thermal annealing in a low-pressure oxygen atmosphere; depositing an i-type silicon layer on the p-type or n-type silicon layer; and depositing an n-type or p-type silicon layer on the i-type silicon layer.

9. A solar cell having at least a first electrode, polycrystalline silicon layers in a PIN or NIP structure, and a second electrode, which are deposited in sequence on an electrically insulating substrate,
wherein the polycrystalline silicon layers comprise a p-type silicon layer, an i-type silicon layer, and an n-type silicon layer, which are deposited in sequence or in reverse, and the p-type silicon layer or the n-type silicon layer, whichever is on the side of closer to the electrically insulating substrate with respect to the i-type silicon layer, has been subjected to thermal annealing.

10. A solar cell having at least a first electrode, polycrystalline silicon layers in a PIN or NIP structure, and a second electrode, which are deposited in sequence on an electrically insulating substrate,
wherein the polycrystalline silicon layers comprise a p-type silicon layer, an i-type silicon layer, and an n-type silicon layer, which are deposited in sequence or in reverse, and have an oxide film formed between the i-type silicon layer and the p-type silicon layer or the n-type silicon layer, whichever is on the side closer to the electrically insulating substrate with respect to the i-type silicon layer.

11. A solar cell according to claim 10, wherein the oxide film is formed by carrying out thermal annealing in a low-pressure oxygen atmosphere after the p-type silicon layer or the n-type silicon layer is deposited on the first electrode.
